# EUROPEAN PATENT APPLICATION

(11) **EP 4 495 638 A1**
(43) Date of publication of application: **22.01.2025**
(21) Application number: 24190161.0
(22) Date of filing: 22.07.2024
(51) Int. Cl.: G01V 20/00, G06T 17/05

(54) **UNSTRUCTURED GRID CELL SUBDIVISION**

(30) Priority: 21.07.2023 US 202318356759
(71) Applicant: Services Pétroliers Schlumberger, 75007 Paris (FR); GeoQuest Systems B.V., 2514 JG The Hague (NL)
(72) Inventor: HARRIS, Simon, Oxford, OX14 4RU (GB); GRENFELL, Stephen, Oxford, OX14 4SH (GB); GOSS, Keith, Oxford, OX14 4RU (GB)
(74) Representative: Schlumberger Intellectual Property Department

(57) **Abstract**

A method includes setting a target value for a coordinate direction of a depositional space to define a cutting plane that cuts a depogrid cell at the target value in the coordinate direction. The method further includes generating a cutting polygon that bounds a planar region of the cutting plane to define a cutting surface at the target value that subdivides the depogrid cell into a plurality of depogrid cells in the coordinate direction. The cutting surface provides common planar surfaces between the plurality of depogrid cells in the depositional space. The method further includes transforming the cutting surface to a geological space using vertices of the cutting polygon and a correspondence mapping that defines a relationship between depositional coordinates and geological coordinates. The cutting surface provides common non-planar surfaces between the plurality of depogrid cells in the geological space.

## Description

### INTRODUCTION

This disclosure relates generally to geological modeling and/or simulation.

### BACKGROUND

Grids can be used to model various features of a sedimentary basin. Each grid cell defined by the grid can represent a discrete region or volume of the sedimentary basin. Reservoir simulation can involve simulating phenomena associated with a sedimentary basin (e.g., a subsurface region) using a grid. A grid can be a structured grid when each grid cell is uniformly addressable by index in each spatial dimension of the grid. Structured grids can include geometrical constraints (e.g., grid cells cannot span features of a modeled sedimentary basin such as faults) to maintain uniformly addressable grid cells. Information obtained from reservoir simulation can useful in various contexts. For example, oil and gas enterprises can use such information to identify potential reservoir locations for hydrocarbons, provide input for well treatment operations, inform well planning, and other purposes relating to oil and gas field operations.

A local grid refinement (LGR) is a subdivision of a grid cell within a grid that corresponds to a specific region of a modeled sedimentary basin where more accurate understanding of flow behavior is needed by reservoir engineers. Structured grids have relatively simple grid cell geometry that facilitates LGR subdivision. For example, subdivision of each grid cell in a structured grid can be considered in isolation provided that the topological connections of grid cells through their faces are maintained. Multiple subdivisions of grid cells in a given spatial direction of a structured grid involves calculating new vertices and shared face geometry. Multiple subdivisions of grid cells in a given spatial direction of a structured grid also involves managing connections between a combined global grid of the structured grid and child cells formed by the multiple iterations of subdivision. Managing connections and calculating new vertices or shared faced geometry while observing geometrical constraints of a structured grid can be non-trivial and demand resources that scale nonlinearly with increasing iterations of subdivision.

This section is intended to introduce the reader to various aspects of art that may be related to various aspects of the present techniques, which are described and/or claimed below. This discussion is believed to be helpful in providing the reader with background information to facilitate a better understanding of the various aspects of this disclosure. Accordingly, it should be understood that these statements are to be read in this light, and not as admissions of prior art.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

One aspect of the present disclosure relates to a method. The method includes setting a target value for a coordinate direction of a depositional space to define a cutting plane that cuts a depogrid cell at the target value in the coordinate direction. The method further includes generating a cutting polygon that bounds a planar region of the cutting plane to define a cutting surface at the target value that subdivides the depogrid cell into a plurality of depogrid cells in the coordinate direction. The cutting surface provides common planar surfaces between the plurality of depogrid cells in the depositional space. The method further includes transforming the cutting surface to a geological space using vertices of the cutting polygon and a correspondence mapping that defines a relationship between depositional coordinates and geological coordinates. The cutting surface provides common non-planar surfaces between the plurality of depogrid cells in the geological space.

One aspect of the present disclosure relates to a system. The system comprises a processor and memory operatively coupled to the processor. The memory storing instructions that, when executed by the processor, cause the system to set a target value for a coordinate direction of a depositional space to define a cutting plane that cuts a depogrid cell at the target value in the coordinate direction. Further, the instructions, when executed by the processor, also cause the system to generate a cutting polygon that bounds a planar region of the cutting plane to define a cutting surface at the target value that subdivides the depogrid cell into a plurality of depogrid cells in the coordinate direction. Further still, the instructions, when executed by the processor, also cause the system to triangulate the cutting surface in the depositional space using vertices of the cutting polygon to create a set of triangular surfaces. The set of triangular surfaces provides common planar surfaces between the plurality of depogrid cells in the depositional space. Further still, the instructions, when executed by the processor, also cause the system to transform the set of triangular surfaces to a geological space using a correspondence mapping and the vertices of the cutting polygon. The correspondence mapping defines a relationship between depositional coordinates and geological coordinates. The set of triangular surfaces provides common non-planar surfaces between the plurality of depogrid cells in the geological space.

One aspect of the present disclosure is directed to a non-transitory computer-readable medium comprising computer-executable instructions that, when executed, are configured to cause a processor to perform operations. The operations comprise setting, by the processor, a target value for a coordinate direction of a depositional space to define a cutting plane that cuts a depogrid cell at the target value in the coordinate direction. The operations further comprise generating, by the processor, a cutting polygon that bounds a planar region of the cutting plane at the target value. The operations further comprise generating, by the processor, a control point in the depositional space using a ray that extends orthogonally with respect to the cutting plane. The cutting polygon and the control point define a cutting surface at the target value that subdivides the depogrid cell into a plurality of depogrid cells in the coordinate direction. The cutting surface provides common planar surfaces between the plurality of depogrid cells in the depositional space. The operations further comprise transforming, by the processor, the cutting surface to a geological space using a correspondence mapping, the control point, and vertices of the cutting polygon. The correspondence mapping defines a relationship between depositional coordinates and geological coordinates. The cutting surface provides common non-planar surfaces between the plurality of depogrid cells in the geological space.

Various refinements of the features noted above may be made in relation to various aspects of this disclosure. Further features may also be incorporated in these various aspects as well. These refinements and additional features may be made individually or in any combination. For instance, various features discussed below in relation to one or more of the illustrated embodiments may be incorporated into any of the above-described aspects of this disclosure alone or in any combination. The brief summary presented above is intended only to familiarize the reader with certain aspects and contexts of embodiments of this disclosure without limitation to the claimed subject matter.

For clarity and simplicity of description, not all combinations of elements provided in the aspects of the invention recited above have been set forth expressly. Notwithstanding this, the skilled person will directly and unambiguously recognize that unless it is not technically possible, or it is explicitly stated to the contrary, the consistory clauses referring to one aspect of the embodiments described herein are intended to apply mutatis mutandis as optional features of every other aspect of the invention to which those consistory clauses could possibly relate.

### BRIEF DESCRIPTION OF THE DRAWINGS

Various features, aspects, and advantages of this disclosure will become better understood when the following detailed description is read with reference to the accompanying figures in which like characters represent like parts throughout the figures, wherein:
**FIG. 1** illustrates an example of a system that includes various management components to manage various aspects of a geologic environment, according to one or more embodiments of this disclosure;
**FIG. 2** illustrates structural model representations of a subterranean environment, according to one or more embodiments of this disclosure;
**FIGS. 3A-3F** illustrate subdivision of a simplified unstructured cell, according to one or more embodiments of this disclosure;
**FIGS. 4A-4D** illustrate multiple subdivisions of a simplified unstructured grid cell, according to one or more embodiments of this disclosure;
**FIGS. 5A-5D** illustrate subdivision of a non-simplified unstructured cell at a well top, according to one or more embodiments of this disclosure;
**FIGS. 6A-6C** illustrate subdivision of a non-simplified unstructured cell at an unconformity, according to one or more embodiments of this disclosure;
**FIGS. 7A-7C** illustrate subdivision of a non-simplified unstructured cell at a fault, according to one or more embodiments of this disclosure;
**FIGS. 8A-8C** illustrate subdivision of a non-simplified unstructured cell representing a dying fault cell, according to one or more embodiments of this disclosure;
**FIG. 9** illustrates a process flow diagram of a method for subdividing depogrid cells of an unstructured grid, in accordance with an aspect of the present disclosure; and
**FIG. 10** illustrates a schematic view of a computing system, in accordance with an aspect of the present disclosure.

### DETAILED DESCRIPTION

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

The drawing figures are not necessarily to scale. Certain features of the embodiments may be shown exaggerated in scale or in somewhat schematic form, and some details of conventional elements may not be shown in the interest of clarity and conciseness. Although one or more embodiments may be preferred, the embodiments disclosed should not be interpreted, or otherwise used, as limiting the scope of the disclosure, including the claims. It is to be fully recognized that the different teachings of the embodiments discussed may be employed separately or in any suitable combination to produce desired results. In addition, one skilled in the art will understand that the description has broad application, and the discussion of any embodiment is meant only to be exemplary of that embodiment, and not intended to intimate that the scope of the disclosure, including the claims, is limited to that embodiment.

When introducing elements of various embodiments of this disclosure, the articles "a," "an," and "the" are intended to mean that there are one or more of the elements. The terms "including" and "having" are used in an open-ended fashion, and thus should be interpreted to mean "including, but not limited to ...." Any use of any form of the terms "couple," or any other term describing an interaction between elements is intended to mean either an indirect or a direct interaction between the elements described.

Certain terms are used throughout the description and claims to refer to particular features or components. As one skilled in the art will appreciate, different persons may refer to the same feature or component by different names. This document does not intend to distinguish between components or features that differ in name but not function, unless specifically stated.

Reference throughout this specification to "one embodiment," "an embodiment," "embodiments," "some embodiments," "certain embodiments," or similar language means that a particular feature, structure, or characteristic described in connection with the embodiment may be included in at least one embodiment of this disclosure. Thus, these phrases or similar language throughout this specification may, but do not necessarily, all refer to the same embodiment. Although this disclosure has been described with respect to specific details, it is not intended that such details should be regarded as limitations on the scope of this disclosure, except to the extent that they are included in the accompanying claims.

Additionally, the methods and processes described below may be performed by a processor. Moreover, the term "processor" should not be construed to limit the embodiments disclosed herein to any particular device type or system. The processor may include a computer system. The computer system may also include a computer processor (e.g., a microprocessor, microcontroller, digital signal processor, or general-purpose computer) for executing any of the methods and processes described below.

The computer system may further include a memory such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

Some of the methods and processes described below, can be implemented as computer program logic for use with the computer processor. The computer program logic may be embodied in various forms, including a source code form or a computer executable form. Source code may include a series of computer program instructions in a variety of programming languages (e.g., an object code, an assembly language, or a high-level language such as C, C++, or JAVA). Such computer instructions can be stored in a non-transitory computer readable medium (e.g., memory) and executed by the computer processor. The computer instructions may be distributed in any form as a removable storage medium with accompanying printed or electronic documentation (e.g., shrink wrapped software), preloaded with a computer system (e.g., on system ROM or fixed disk), or distributed from a server or electronic bulletin board over a communication system (e.g., the Internet or World Wide Web).

Alternatively or additionally, the processor may include discrete electronic components coupled to a printed circuit board, integrated circuitry (e.g., Application Specific Integrated Circuits (ASIC)), and/or programmable logic devices (e.g., a Field Programmable Gate Arrays (FPGA)). Any of the methods and processes described below can be implemented using such logic devices.

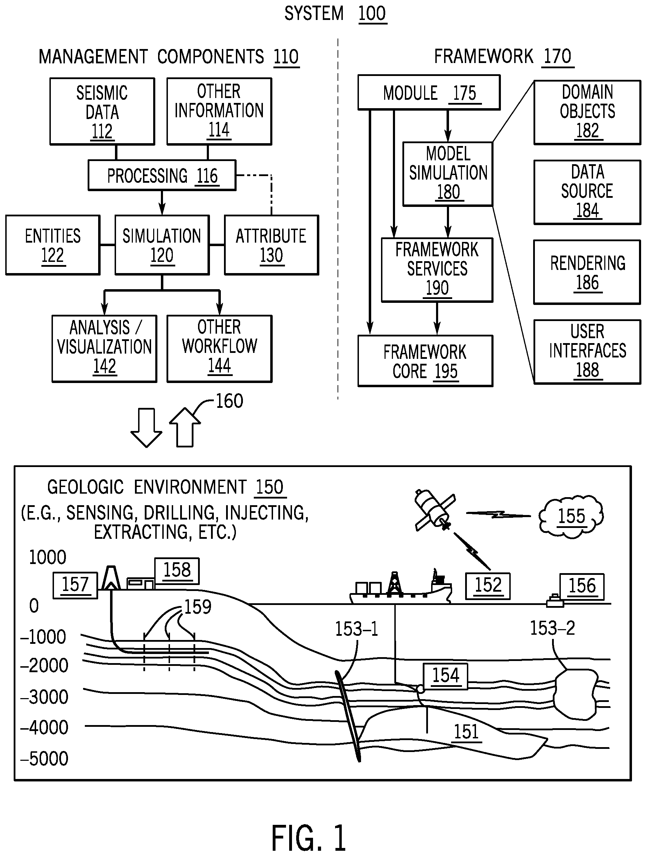

**FIG. 1** illustrates an example of a system 100 that includes various management components 110 to manage various aspects of a geologic environment 150 (e.g., an environment that includes a sedimentary basin, a reservoir 151, one or more faults 153-1, one or more geobodies 153-2, etc.). For example, the management components 110 may allow for direct or indirect management of sensing, drilling, injecting, extracting, etc., with respect to the geologic environment 150. In turn, further information about the geologic environment 150 may become available as feedback 160 (e.g., optionally as input to one or more of the management components 110).

In the example of **FIG. 1****,** the management components 110 include a seismic data component 112, an additional information component 114 (e.g., well/logging data), a processing component 116, a simulation component 120, an attribute component 130, an analysis/visualization component 142 and a workflow component 144. In operation, seismic data and other information provided per the components 112 and 114 may be input to the simulation component 120.

In an example embodiment, the simulation component 120 may rely on entities 122. Entities 122 may include earth entities or geological objects such as wells, surfaces, bodies, reservoirs, etc. In the system 100, the entities 122 can include virtual representations of actual physical entities that are reconstructed for purposes of simulation. The entities 122 may include entities based on data acquired via sensing, observation, etc. (e.g., the seismic data 112 and other information 114). An entity may be characterized by one or more properties (e.g., a geometrical pillar grid entity of an earth model may be characterized by a porosity property). Such properties may represent one or more measurements (e.g., acquired data), calculations, etc.

In an example embodiment, the simulation component 120 may operate in conjunction with a software framework such as an object-based framework. In such a framework, entities may include entities based on pre-defined classes to facilitate modeling and simulation. A commercially available example of an object-based framework is the MICROSOFT^{®} .NET^{®} framework (Redmond, Wash.), which provides a set of extensible object classes. In the .NET^{®} framework, an object class encapsulates a module of reusable code and associated data structures. Object classes can be used to instantiate object instances for use in by a program, script, etc. For example, borehole classes may define objects for representing boreholes based on well data.

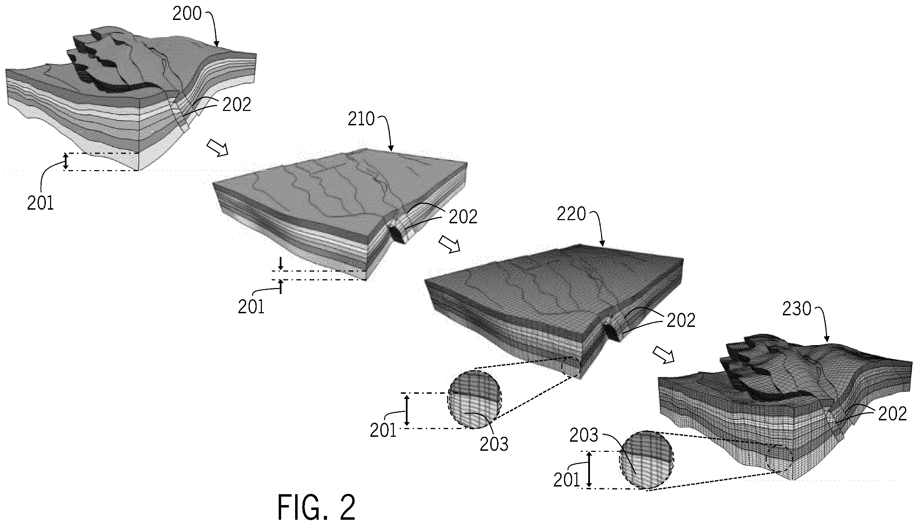

In the example of **FIG. 1****,** the simulation component 120 may process information to conform to one or more attributes specified by the attribute component 130, which may include a library of attributes. Such processing may occur prior to input to the simulation component 120 (e.g., consider the processing component 116). As an example, the simulation component 120 may perform operations on input information based on one or more attributes specified by the attribute component 130. In an example embodiment, the simulation component 120 may construct one or more models (e.g., the structural model 200, the depositional model 210, the gridded model 220, and/or the depogrid 230 of **FIG. 2**) of the geologic environment 150, which may be relied on to simulate behavior of the geologic environment 150 (e.g., responsive to one or more acts, whether natural or artificial). In the example of **FIG. 1****,** the analysis/visualization component 142 may allow for interaction with a model or model-based results (e.g., simulation results, etc.). As an example, output from the simulation component 120 may be input to one or more other workflows, as indicated by a workflow component 144.

As an example, the simulation component 120 may include one or more features of a simulator such as the ECLIPSE^{™} reservoir simulator (SLB, Houston Tex.), the INTERSECT^{™} reservoir simulator (SLB, Houston Tex.), etc. As an example, a simulation component, a simulator, etc. may include features to implement one or more meshless techniques (e.g., to solve one or more equations, etc.). As an example, a reservoir or reservoirs may be simulated with respect to one or more enhanced recovery techniques (e.g., consider a thermal process such as SAGD, etc.).

In an example embodiment, the management components 110 may include features of a commercially available framework such as the PETREL^{®} seismic to simulation software framework (SLB, Houston, Tex.). The PETREL^{®} framework provides components that allow for optimization of exploration and development operations. The PETREL^{®} framework includes seismic to simulation software components that can output information for use in increasing reservoir performance, for example, by improving asset team productivity. Through use of such a framework, various professionals (e.g., geophysicists, geologists, and reservoir engineers) can develop collaborative workflows and integrate operations to streamline processes. Such a framework may be considered an application and may be considered a data-driven application (e.g., where data is input for purposes of modeling, simulating, etc.).

In an example embodiment, various aspects of the management components 110 may include add-ons or plug-ins that operate according to specifications of a framework environment. For example, a commercially available framework environment marketed as the OCEAN^{®} framework environment (SLB, Houston, Tex.) allows for integration of add-ons (or plug-ins) into a PETREL^{®} framework workflow. The OCEAN^{®} framework environment leverages .NET^{®} tools (Microsoft Corporation, Redmond, Wash.) and offers stable, user-friendly interfaces for efficient development. In an example embodiment, various components may be implemented as add-ons (or plug-ins) that conform to and operate according to specifications of a framework environment (e.g., according to application programming interface (API) specifications, etc.).

**FIG. 1** also shows an example of a framework 170 that includes a model simulation layer 180 along with a framework services layer 190, a framework core layer 195 and a modules layer 175. The framework 170 may include the commercially available OCEAN^{®} framework where the model simulation layer 180 is the commercially available PETREL^{®} model-centric software package that hosts OCEAN^{®} framework applications. In an example embodiment, the PETREL^{®} software may be considered a data-driven application. The PETREL^{®} software can include a framework for model building and visualization.

As an example, a framework may include features for implementing one or more model generation techniques. For example, a framework may include an input component for receipt of information from interpretation of seismic data, one or more attributes based at least in part on seismic data, log data, image data, etc. Such a framework may include a model generation component that processes input information, optionally in conjunction with other information, to generate a model of a subterranean environment or volume. As an example, a model may be a mesh or a grid. Such constructs (e.g., models, meshes or grids) may be defined by nodes, cells, intervals, segments, etc.

In the example of **FIG. 1****,** the model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

As an example, the domain objects 182 can include entity objects, property objects and optionally other objects. Entity objects may be used to geometrically represent wells, surfaces, bodies, reservoirs, etc., while property objects may be used to provide property values as well as data versions and display parameters. For example, an entity object may represent a well where a property object provides log information as well as version information and display information (e.g., to display the well as part of a model, such as the structural model 200, the depositional model 210, the gridded model 220, and/or the depogrid 230 of **FIG. 2**).

In the example of **FIG. 1****,** data may be stored in one or more data sources (or data stores, generally physical data storage devices), which may be at the same or different physical sites and accessible via one or more networks. The model simulation layer 180 may be configured to model projects. As such, a particular project may be stored where stored project information may include inputs, models, results and cases. Thus, upon completion of a modeling session, a user may store a project. At a later time, the project can be accessed and restored using the model simulation layer 180, which can recreate instances of the relevant domain objects.

In the example of **FIG. 1****,** the geologic environment 150 may include zones (e.g., stratification) that include a reservoir 151 and one or more other features such as the fault 153-1, the geobody 153-2, etc. As an example, the geologic environment 150 may be outfitted with any of a variety of sensors, detectors, actuators, etc. For example, equipment 152 may include communication circuitry to receive and to transmit information with respect to one or more networks 155. Such information may include information associated with downhole equipment 154, which may be equipment to acquire information, to assist with resource recovery, etc. Other equipment 156 may be located remote from a well site and include sensing, detecting, emitting or other circuitry. Such equipment may include storage and communication circuitry to store and to communicate data, instructions, etc. As an example, one or more satellites may be provided for purposes of communications, data acquisition, etc. For example, **FIG. 1** shows a satellite in communication with the network 155 that may be configured for communications, noting that the satellite may additionally or instead include circuitry for imagery (e.g., spatial, spectral, temporal, radiometric, etc.).

**FIG. 1** also shows the geologic environment 150 as optionally including equipment 157 and 158 associated with a well that includes a substantially horizontal portion that may intersect with one or more fractures 159. For example, consider a well in a shale formation that may include natural fractures, artificial fractures (e.g., hydraulic fractures) or a combination of natural and artificial fractures. As an example, a well may be drilled for a reservoir that is laterally extensive. In such an example, lateral variations in properties, stresses, etc. may exist where an assessment of such variations may assist with planning, operations, etc. to develop a laterally extensive reservoir (e.g., via fracturing, injecting, extracting, etc.). As an example, the equipment 157 and/or 158 may include components, a system, systems, etc. for fracturing, seismic sensing, analysis of seismic data, assessment of one or more fractures, etc.

As mentioned, the system 100 may be used to perform one or more workflows. A workflow may be a process that includes a number of worksteps. A workstep may operate on data, for example, to create new data, to update existing data, etc. As an example, a workflow may operate on one or more inputs and create one or more results, for example, based on one or more algorithms. As an example, a system may include a workflow editor for creation, editing, executing, etc. of a workflow. In such an example, the workflow editor may provide for selection of one or more pre-defined worksteps, one or more customized worksteps, etc. As an example, a workflow may be a workflow implementable in the PETREL^{®} software, for example, that operates on seismic data, seismic attribute(s), etc. As an example, a workflow may be a process implementable in the OCEAN^{®} framework. As an example, a workflow may include one or more worksteps that access a module such as a plug-in (e.g., external executable code, etc.).

**FIG. 2** shows various model representations of a volume or portion of a subterranean environment (subterranean volume), according to one or more embodiments of this disclosure. A structural model 200 of the subterranean volume can be generated, in geological space, using data representing properties of the subterranean volume. Such data can include core sample data, seismic data, image data, sensor data, well log data, and/or any other data representing properties of the subterranean volume. As discussed above with respect to **FIG. 1****,** the system 100 may include features of a commercially available framework (e.g., the framework 170) that provide components that allow for optimization of exploration and development operations. For example, the PETREL^{®} software can include a framework for model building and visualization that includes an input component for receipt of information from interpretation of seismic data and/or other data representing properties of a subterranean volume such as one or more attributes of the subterranean volume based at least in part on the seismic data and/or other data representing properties of a subterranean volume. That framework of the PETREL^{®} software may also include a model generation component that processes input information, optionally in conjunction with other information, to generate a model (e.g., the structural model 200) of the subterranean volume in geological space. In at least one embodiment, the model generation component can process the input information using a volume-based algorithm that defines a stratigraphic function within a subterranean volume. Conformable horizons can be isosurfaces of the stratigraphic function. Faults and other unconformities can represent discontinuities of the stratigraphic function. The stratigraphic function can include a numerical solution per geological sequence based on corresponding input fault and horizon interpretations.

The structural model 200 includes various geologic features (e.g., stratigraphic zones, faults, and/or other geologic features) that form a geology of the subterranean volume. The geology of the subterranean volume represented by the structural model 200 includes a number of stratigraphic zones 201 and a number of faults 202. The presence of the faults 202 may render the zones 201 discontinuous and offset across the faults 202. As shown by the structural model 200, the zones 201 may have relatively complex geometries associated with the faults 202 in geological space.

The structural model 200 also includes geological coordinates for the various geologic features that describe a spatial arrangement of the various geologic features within a coordinate system of geological space. Various embodiments of this disclosure describe the coordinate system of geological space in the context of a Cartesian coordinate system where (X, Y, Z) coordinates are used to define position. In at least one embodiment, the coordinate system of geological space is a non-Cartesian coordinate system, such as a cylindrical coordinate system or a spherical coordinate system.

Another model, a depositional model 210, is generated by transforming (e.g., mechanically, geometrically, and/or using structural restoration) the structural model 200 in geological space to depositional space. The subterranean volume that the depositional model 210 represents in depositional space is the same subterranean volume that the structural model 200 represents in geological space. In depositional space, conformable horizons are represented as horizontal planes and fault offsets are removed. Depositional space is represented by an orthogonal coordinate system (U, V, W) with the vertical coordinate, W, defining a geological time parameter. Transforming the structural model 200 in geological space to depositional space involves defining a one-to-one mapping (except at the faults 202) between points of the structural model 200 in geological space and corresponding points of the depositional model 210 in depositional space. Defining the one-to-one mapping can involve generating or creating global arrays of dual depositional and geological space coordinates. Respective points or vertices of each model (e.g., the structural model 200) in a given space (e.g., geological space) can be indexed to the global arrays of dual depositional and geological space coordinates. The global arrays can form a correspondence mapping that defines a relationship or association between (U, V, W) depositional coordinates of depositional space and (X, Y, Z) geological coordinates of geological space.

A gridded model 220 is generated by uniformly gridding the structural model 200 in depositional space. To that end, the gridded model 220 is generated by applying a grid in depositional space to the depositional model 210 that partitions the depositional model 210 into cells representing discrete portions of the subterranean volume. Applying the grid in depositional space to the depositional model 210 can involve receiving input (e.g., user input) per geological sequence that sets a slicing orientation and increments in the horizontal (U, V) directions. In depositional space, the slicing orientation and increments in the horizontal (U, V) directions can define cutting locations that are applied to the depositional model 210 as vertical cutting planes to uniformly slice the depositional model 210 in the horizontal (U, V) directions. Applying the grid in depositional space to the depositional model 210 can also involve receiving input (e.g., user input) per geological sequence that sets a number of layers 203 per zone 201 in the vertical (W) direction. In depositional space, the number of layers 203 per zone 201 in the vertical (W) direction can define cutting locations that are applied to the depositional model 210 as horizontal cutting planes to uniformly slice the depositional model 210 in the vertical (W) direction. By applying the grid in depositional space, the depositional model 210 is sliced uniformly in the horizontal (U, V) directions and each zone of the zones 201 is sliced uniformly into a number of layers 203 in the vertical (W) direction. The gridded model 220 thereby represents the subterranean volume in depositional space as a grid of uniformed shaped cells in the vertical (W) direction that are each aligned to the orthogonal axes of the orthogonal coordinate system (U, V, W). The faults 202 are precisely represented in the gridded model 220 as cut cells in depositional space.

An inverse of the one-to-one mapping defined for transforming the structural model 200 to depositional space is applied to the gridded model 220 (except at the faults 202) in depositional space to generate another model, a depogrid 230, in geological space. Applying the inverse of that one-to-one mapping to the gridded model 220 in depositional space maintains the correspondence between points in geological and depositional spaces. Accordingly, the zones 201 and the faults 202 of the depogrid 230 accurately match those of the initial structural model 200, as shown by **FIG. 2****.** Moreover, the additional layers 203 between the seismic horizons honor the stratigraphic nature of the depositional mapping. When viewed in geological space, the W coordinate lines retain their orthogonal relationship with the local seismic horizons that was enforced in depositional space. The correspondence between points in depositional and geological spaces described above will be used later to define the subdivision of depogrid cells or other unstructured grid cells.

Aspects of the present disclosure provide techniques for subdividing depogrid cells of an unstructured grid whilst preserving certain features of the unstructured grid's relationship to depositional space. Generating a depogrid such as the depogrid 230 in accordance with the grid creation workflow described above with reference to **FIG. 2** provides a natural basis for labeling each face of a given depogrid cell. For example, depogrid cell faces corresponding to horizons can be labelled by that horizon. Another example, depogrid cell faces corresponding to the U, V, or W direction slicing of a depositional model (e.g., the depositional model 210) in depositional space can be labelled by a slicing index and the U-direction, V-direction, or W-direction. As described above, the gridded model 220 is generated by uniformly gridding the structural model 200 in depositional space. In this example, a given depogrid cell can be referenced by a set of slicing indices where each slicing index corresponds to a cutting plane in a given direction of depositional space. Another example, depogrid cell faces corresponding to cut cells at faults (e.g., the faults 202) can be labelled by fault index and a side (e.g., footwall or hanging wall) of a corresponding fault.

Depogrid cell faces within an interior of a depogrid or depogrid cell faces that are non-adjacent to a model discontinuity (e.g., a grid boundary, a fault, or unconformity) are generally shared by two depogrid cells with a connection between the two depogrid cells being implicitly defined. Grid cell connections through depogrid cell faces that are adjacent to a model discontinuity (e.g., a grid boundary, a fault, or unconformity) are generally explicitly defined as non-neighbor connections ("NNCs"). NNCs are generally defined by a face of a first depogrid cell, a cell index of the first depogrid cell, a face of a second depogrid cell, and a cell index of the second depogrid cell.

In accordance with one or more embodiments of the present disclosure, a graph structure (e.g., a directional hierarchical acyclic graph structure) stores depogrid data that defines a depogrid. The graph structure can be implemented to preserve correspondence between depogrid elements in (U, V, W) depositional coordinates of depositional space and in (X, Y, Z) geological coordinates of geological space. To that end, the graph structure can include graph nodes that represent cells, faces, edges, and vertices of a depogrid. Such graph nodes can include root grid nodes, cell nodes, face nodes, edge nodes, and vertex nodes.

A root grid node can represent a depogrid or another unstructured grid. A root grid node can include a list of indices into a cell nodes list. For example, a root grid node can include a list of depogrid cells or other unstructured grid cells to be subdivided. A cell node can represent a depogrid cell of the depogrid. A cell node can include a list of indices into a face nodes list. An index within a list of indices into a face nodes list can have a corresponding face node graph direction. A positive face node graph direction can be consistent with an implicit face node direction. A negative face node graph direction be opposite of an implicit face node direction. In an embodiment, depogrid cell represented by a cell node can be a complex, self-intersecting, and/or concave polyhedron.

A face node can represent a face of a depogrid cell. Face nodes of a face nodes list can represent faces of a depogrid cell represented by a cell node that includes an index into the face node list and a face direction. Generally, a face node is shared by two cell nodes. At a model discontinuity (e.g., a grid boundary, a fault, or unconformity), a face node generally has a single connected cell node. A face node can represent a surface of a depogrid cell in depositional space. For example, convexity of a face node in (U, V, W) depositional coordinates of depositional space can be useful to ensure that cutting planes (e.g., U-cutting planes, V-cutting planes, or W-cutting planes) intersect at most two edge nodes of the face node.

A face node can include a list of indices into an edge nodes list. An edge node of an edge node list can represent an edge of a face represented by a given face node. An index within a list of indices into an edge nodes list can have a corresponding edge node graph direction. A positive edge node graph direction can be consistent with an implicit edge node direction. A negative face node graph direction be opposite of an implicit edge node direction. In an embodiment, a face node can include a list of indices into an edge nodes list that is an ordered list of edge node indices and directions. In this embodiment, edges represented by edge nodes in the edge nodes list can sequentially join to define a continuous and directed (e.g., a positive face node graph direction) boundary to the face node.

An edge node can represent an edge of a surface of a depogrid cell. Edge nodes of an edge nodes list can represent edges of a surface represented by a face node that includes a list of indices into the edge node list. An edge node can be shared by two face nodes of a given cell node. An edge node can include two vertex topology indices corresponding to two vertex nodes. Each vertex node can represent a vertex of an edge of a surface of a depogrid cell. Assigning a start vertex label to one vertex node associated with a given edge node and an end vertex label to another vertex node associated with the given edge node can imply a positive edge node direction.

A vertex node can include a location of a vertex in (U, V, W) depositional coordinates of depositional space and a corresponding location of the vertex in (X, Y, Z) geological coordinates of geological space. Each vertex represented by such vertex nodes has dual correspondence in (X, Y, Z) geological coordinates of geological space and in (U, V, W) depositional coordinates of depositional space. Depogrid vertices represented by such vertex nodes can be indexed to global arrays of dual depositional and geological space coordinates. Such global arrays can form a correspondence mapping that defines a relationship or association between (U, V, W) depositional coordinates of depositional space and (X, Y, Z) geological coordinates of geological space. A position of each depogrid element (e.g., vertices, cells, faces, and edges) in one dual space (e.g., depositional space) can be mapped to a corresponding position in another dual space (e.g., geological space) using the correspondence mapping and depogrid vertices of that depogrid element. For example, a depogrid can include an edge that comprises multiple vertices. A position of the edge in depositional space can be mapped to a corresponding position in geological space (and vice-versa) using the correspondence mapping and (U, V, W) depositional coordinates of the multiple vertices.

Subdivision of depogrids involves generating or creating new depogrid elements (e.g., cells, faces, edges, and/or vertices) that replace existing depogrid elements. As discussed above with respect to **FIG. 1****,** the system 100 may include features of a commercially available framework (e.g., the framework 170) that provide components that allow for optimization of exploration and development operations. For example, the PETREL^{®} software can include a framework for model building and visualization that comprises simulation software components that can output information for use in increasing reservoir performance. Reservoir engineers or other professionals can use such components to construct one or more models (e.g., the depogrid 230 of **FIG. 2**) of a geologic environment (e.g., the geologic environment 150 of **FIG. 1**) that can be relied on to simulate behavior of the geologic environment.

In some instances, reservoir engineers or other professionals may identify a region of a geologic environment where simulating behavior (e.g., flow behavior) of the geologic environment with greater accuracy may be helpful in increasing reservoir performance. For example, simulating flow behavior with greater accuracy in a region of the geologic environment close to a well, proximate to a fluid contact (e.g., an oil-water contact), or where flow behavior changes rapidly, may be helpful in increasing reservoir performance. In such instances, an input (e.g., user input) can be received as part of a visualization, simulation, or modeling workflow implemented using a framework such as the PETREL^{®} framework. The input can select one or more cells of a model (e.g., the depogrid 230 of **FIG. 2**) of the geologic environment. For example, the input can select one or more cells of the model that are within an areal polygon, proximate (e.g., above and/or below) an input surface, within a defined distance of another region of the model that corresponds to a well, and the like. The one or more cells of the model can correspond to the region of the geologic environment where simulating behavior (e.g., flow behavior) of the geologic environment with greater accuracy may be helpful in increasing reservoir performance. Responsive to receiving the input, the visualization, simulation, or modeling workflow can generate a local grid refinement (LGR) within the model by subdividing the one or more cells selected by the input.

For example, a parent cell (e.g., a depogrid cell that exists prior to subdivision) of a depogrid can be partitioned during subdivision to generate or create two child cells (e.g., new depogrid cells that did not exist prior to subdivision) that replace the parent cell in the depogrid. In accordance with one or more embodiments of the present disclosure, a graph structure (e.g., a directional hierarchical acyclic graph structure) storing depogrid cell data can be implemented to manage depogrid element creation and replacement during subdivision. To that end, graph nodes representing new depogrid elements that are generated or created during subdivision can be designated as "replacing" nodes. Graph nodes (e.g., cell nodes, face nodes, edge nodes, and/or vertex nodes) representing existing depogrid elements that are replaced by new depogrid elements can be designated as "replaced" nodes. In general, a graph node representing a given type of depogrid element can be designated as a replaced node in the graph structure responsive to providing a list of replacing nodes that each represent the same given type of depogrid element as the replaced node.

Subdividing a depogrid cell (e.g., a parent depogrid cell) in a specific coordinate direction (e.g., a U-direction, a V-direction, or a W-direction) of depositional space involves generating or creating a cutting polygon. To that end, a target value is set for the specific coordinate direction of depositional space to define a cutting plane. The cutting plane cuts or slices the depogrid cell at the target value in the specific coordinate direction of depositional space to generate or create the cutting polygon. The cutting polygon bounds a planar region of the cutting plane to define a cutting surface at the target value in the specific coordinate direction of depositional space. The specific coordinate direction of depositional space can be referred to as a cutting direction inasmuch as the cutting plane cuts or slices the depogrid cell at the target value in the specific coordinate direction. The cutting surface subdivides the depogrid cell into multiple depogrid cells (e.g., two child depogrid cells) in the specific coordinate direction of depositional space. The cutting surface provides common intermediate surfaces between the multiple depogrid cells that are formed by subdivision of the depogrid cell in the specific coordinate direction of depositional space. While a depogrid cell may be unsuitable for subdivision in geological space (e.g., the depogrid cell in geological space may be excessively distorted for subdivision), convexity of surfaces in depositional space generally ensures that a target value only occurs in two edges of given surface of the depogrid cell in depositional space.

For example, a depogrid cell can be subdivided in the W-direction of depositional space. In this example, a target W value is set for the W-direction of depositional space to define a W-cutting plane. The W-cutting plane of this example cuts or slices the depogrid cell at the target W value in the W-direction of depositional space to generate or create a cutting polygon. The cutting polygon bounds a planar region of the cutting plane to define a W-cutting surface at the target W value in the W-direction of depositional space. The W-cutting surface subdivides the depogrid cell into multiple depogrid cells (e.g., two child depogrid cells) in the W-direction of depositional space. The W-cutting surface provides common intermediate surfaces between the multiple depogrid cells that are formed by subdivision of the depogrid cell in the W-direction of depositional space.

Another example, a depogrid cell can be subdivided in the U-direction of depositional space. In this example, a target U value is set for the U-direction of depositional space to define a U-cutting plane. The U-cutting plane of this example cuts or slices the depogrid cell at the target U value in the U-direction of depositional space to generate or create a cutting polygon. The cutting polygon bounds a planar region of the cutting plane to define a U-cutting surface at the target U value in the U-direction of depositional space. The U-cutting surface subdivides the depogrid cell into multiple depogrid cells (e.g., two child depogrid cells) in the U-direction of depositional space. The U-cutting surface provides common intermediate surfaces between the multiple depogrid cells that are formed by subdivision of the depogrid cell in the U-direction of depositional space.

Subdivision of a depogrid cell in a specific coordinate direction (e.g., a U-direction, a V-direction, or a W-direction) of depositional space can be implemented using a graph structure such as the directional hierarchical acyclic graph structure described above. Continuing with the previous example, a graph structure can include a root grid node corresponding to a depogrid that comprises the depogrid cell to be subdivided in the U-direction of depositional space. A cell node corresponding to the depogrid cell to be subdivided in the U-direction can be among a list of cell nodes in that graph structure. In this example, the root grid node can include a list of indices into that cell nodes list.

An edge node representing each edge of the depogrid cell can be evaluated by linear interpolation in depositional space to determine if the edge node contains the target U value. If a face node of the depogrid cell is to be "crossed" by the U-cutting plane, then two edge nodes of the face node are "crossed" by the U-cutting plane. A location of a "crossing point" within an edge node (e.g., a vertex of an edge represented by the edge node at which that edge is "crossed" by the U-cutting plane) has dual correspondence in (X, Y, Z) geological coordinates of geological space and in (U, V, W) depositional coordinates of depositional space. For example, as discussed above, depogrid vertices can indexed to global arrays of dual depositional and geological space coordinates. Such global arrays can form a correspondence mapping that defines a relationship or association between (U, V, W) depositional coordinates of depositional space and (X, Y, Z) geological coordinates of geological space. The dual correspondence provided by the correspondence mapping facilitates defining a cutting polygon in (X, Y, Z) geological coordinates of geological space with proportions that are the same or substantially similar to proportions of a cutting polygon generated for subdividing a depogrid cell in (U, V, W) depositional coordinates of depositional space.

Subdividing the depogrid cell in the U-direction using the graph structure can involve assigning a "side-of-cut" label in the graph structure to every face node, edge node and vertex of the root grid node. Side-of-cut labels can include a "below-cut" label, an "above-cut" label, an "at-cut" label, and/or a "crossing" label. A below-cut label is assigned to nodes of the graph structure having U values in the U-direction that are all either less than or equal to the target U value of the U-cutting plane. In an embodiment, the below-cut label is assigned to nodes having at least one U value in the U-direction that is less than the target U value of the U-cutting plane. An above-cut label is assigned to nodes of the graph structure having U values in the U-direction that are all either greater than or equal to the target U value of the U-cutting plane. In an embodiment, the above-cut label is assigned to nodes having at least one U value in the U-direction that is greater than the target U value of the U-cutting plane. An at-cut label is assigned to nodes of the graph structure having U values in the U-direction that are all equal to the target U value of the U-cutting plane. A crossing label is assigned to nodes of the graph structure having some U values in the U-direction that are less than the target U value of the U-cutting plane and some U values in the U-direction that are greater than the target U value of the U-cutting plane. A cell node of the graph structure is assigned a crossing label when a crossing label is assigned to at least one edge of the cell node. Cell nodes of the graph structure that are assigned a crossing label are subdivided in the U-direction. Conversely, cell nodes of the graph structure that are not assigned a crossing label are excluded from subdivision.

In subdivision, each node of a graph structure assigned a crossing label is removed from the graph structure. Each node removed from the graph structure is replaced with one or more nodes that are assigned an above-cut label, a below-cut label, or an at-cut label. An edge node assigned a crossing label is removed from the graph structure in subdivision. The edge node being replaced in subdivision is a parent edge node that is replaced by introducing into the graph structure a new vertex node that is assigned an at-cut label and two new edge nodes. The two new edge nodes include one edge node that is assigned a below-cut label and another edge node that is assigned an above-cut label. Both of the two new edge nodes inherit a graph link direction of the parent edge node.

A face node assigned a crossing label is also removed from the graph structure in subdivision. The face node being removed in subdivision is a parent face node that is replaced by introducing into the graph structure a new edge node that is assigned an at-cut label and two new face nodes. The new edge node corresponds to an edge that crosses through a face that is represented by the face node being replaced. The new edge node can automatically contain any new vertex nodes generated or created in subdivision by cutting two parent edge nodes (e.g., the two edge nodes of the parent face node that are "crossed" by the U-cutting plane). The two new face nodes include one face node that is assigned a below-cut label and another face node that is assigned an above-cut label. Both of the two new face nodes inherit face assignments of the parent face node. Each new face node is planar in depositional space.

In a current subdivision iteration, parent face nodes are either original face nodes of the root grid node or new face nodes that were introduced by a previous subdivision iteration. A cutting-face label is assigned to a parent face node when introduced by a previous subdivision iteration. A cutting-face label can generally denote a face node that corresponds to a cutting face involved in subdividing a depogrid cell in depositional space. Each new face node replacing a parent face node in a current subdivision iteration inherits a cutting-face label that was assigned to the parent fact node in a previous subdivision iteration. New face nodes replacing parent face nodes that were assigned cutting-face labels in previous subdivision iterations are generally non-planar in geological space. In a current subdivision iteration for a given cell node, a cutting-face label is assigned to at least one new face node generated or generated in that current subdivision iteration. In a subsequent subdivision iteration for the given cell node, that new face node can be considered as both a "cutting face" (e.g., a face node introduced by a previous subdivision iteration) and a "crossing face".

Generating or creating new face nodes involves identifying edge nodes of a given cell node that are assigned at-cut labels. An edge node assigned an at-cut label has a defined positive graph direction in the graph structure. Edge nodes of a given cell node with at-cut labels can be stitched together to form a closed loop of edge nodes using respective vertex topologies of each such edge node. That closed loop of edge nodes generates or creates a new face node. Each new face node is generally planar in depositional space and non-planar in geological space. One or more polygonal edges of such new face nodes may be concave in depositional space.

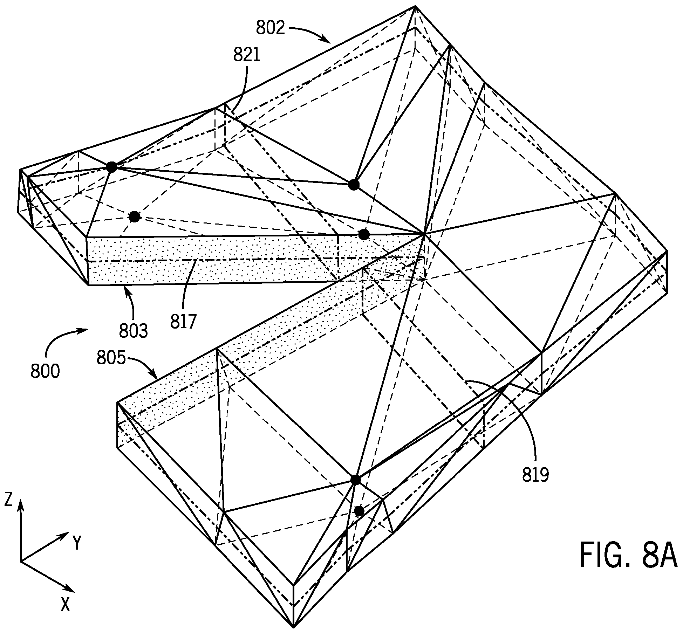

A cell node assigned a crossing label is also removed from the graph structure in subdivision. The cell node being replaced in a given subdivision iteration is a parent cell node. The parent cell node is replaced by introducing into the graph structure at least two new cell nodes. An above-cut label or a below-cut label is assigned to each new cell node. Each new cell node includes a new face node that is assigned a cutting-face label. A new cell node with an above-cut label includes a new face node with a cutting-face label that is a positively directed face node. A new cell node with a below-cut label includes a new face node with a cutting-face label that is a negatively directed face node. A number of new face nodes and a number of new cell nodes introduced into a graph structure by a given subdivision iteration can depend on a geometry of a depogrid cell being subdivided. For example, an embodiment of subdivision described below with respect to **FIGS. 8A-****8C** introduces two new face nodes and three new cell nodes into a graph structure.

Subdividing a depogrid cell in a specific coordinate direction (e.g., a U-direction, a V-direction, or a W-direction) of depositional space also involves triangulation of cutting surfaces (e.g., surfaces that correspond to face nodes with cutting-face labels). Triangulation of cutting surfaces can occur either after each subdivision iteration or after all subdivision iterations for a given depogrid cell have been completed. Triangulation of cutting surfaces can generally be less complex in depositional space where such cutting surfaces are generally planar. Dual correspondence of points in geological space and depositional space can be useful for mapping a topology of a cutting surface generated for a given depogrid cell in depositional space to a corresponding topology in geological space.

Depogrid cells can include simplified depogrid cells and non-simplified depogrid cells. Non-simplified depogrid cell generally denotes a depogrid cell that is adjacent to a model discontinuity (e.g., a grid boundary, a fault, or unconformity) or a depogrid cell that is intersected by a well top. Example unstructured depogrid cells can include cut cells, depogrid cells intersected by well tops, and dying fault cells. Simplified depogrid cell generally denotes a depogrid grid cell that is non-adjacent to a model discontinuity or a depogrid cell that is not intersected by a well top. Additional control points are generally useful for accurately representing cutting surfaces (e.g., surfaces that correspond to face nodes with cutting-face labels) for subdividing non-simplified grid cells. For non-simplified grid cells, additional control points can be introduced at each iteration of subdivision in depositional space to control cutting surface geometries in geological space. Triangulation of cutting surfaces after each subdivision iteration can be useful when additional control points are introduced at each subdivision iteration for non-simplified grid cells.

Simplified grid cells can generally be subdivided without additional control points (e.g., interior vertices on a cutting surface) for controlling cutting surface geometries in geological space. Rather, boundary vertices are generally sufficient for subdividing simplified grid cells. Triangulation of cutting surfaces can be deferred until all subdivision iterations have been applied to a simplified grid cell. Deferring triangulation of cutting surfaces in such instances can be useful for reducing a number of additional face nodes that are generated for a given cutting surface.

In accordance with aspects of the present disclosure, subdividing a depogrid cell (e.g., a parent depogrid cell) generally involves subdividing the depogrid cell in a specific coordinate direction (e.g., a U-direction, a V-direction, or a W-direction) of depositional space. Subdividing the depogrid cell in a specific coordinate direction (e.g., a U-direction, a V-direction, or a W-direction) of depositional space involves generating or creating a cutting polygon. To that end, a target value is set for the specific coordinate direction of depositional space to define a cutting plane. The cutting plane cuts or slices the depogrid cell at the target value in the specific coordinate direction of depositional space to generate or create the cutting polygon. The cutting polygon bounds a planar region of the cutting plane to define a cutting surface at the target value in the specific coordinate direction of depositional space. The specific coordinate direction of depositional space can be referred to as a cutting direction inasmuch as the cutting plane cuts or slices the depogrid cell at the target value in the specific coordinate direction. The cutting surface subdivides the depogrid cell into multiple depogrid cells (e.g., two child depogrid cells) in the specific coordinate direction of depositional space. The cutting surface provides common intermediate surfaces between the multiple depogrid cells that are formed by subdivision of the depogrid cell in the specific coordinate direction of depositional space.

A cutting surface in (U, V, W) depositional coordinates of depositional space is planar inasmuch as the cutting surface is defined in depositional space by cutting polygon that bounds a planar region of depositional space. The cutting surface that is planar in depositional space can have a geological space representation that is non-planar in (X, Y, Z) geological coordinates of geological space. That non-planar geological space representation of the cutting surface in (X, Y, Z) geological coordinates of geological space is generally bounded by a non-planar cutting polygon.

Subdivision of simplified depogrid cells can visually be similar to subdivision of cells of a structured grid (e.g., a pillar grid). One difference between the different subdivision techniques is that subdivision of simplified depogrid cells first occurs in (U, V, W) depositional coordinates of depositional space. New vertices, new surfaces, and new topology generated through such subdivision in depositional space are then mapped back to (X, Y, Z) geological coordinates of geological space using the dual correspondence between the depositional and geological spaces provided by the correspondence mapping. Another difference for subdivision of simplified depogrid cells is that triangulation of cutting surfaces can be postponed until all subdivision iterations for a given depogrid cell have been completed.

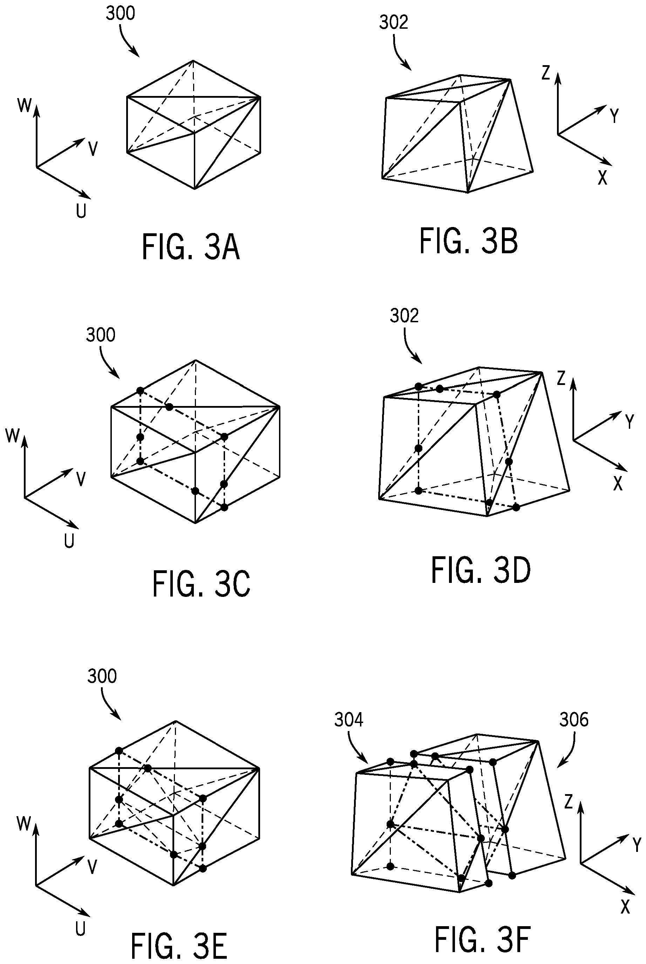

**FIGS. 3A-3F** illustrate subdivision of a simplified depogrid cell, according to one or more embodiments of this disclosure. In some areas of a depogrid or another unstructured grid model (e.g., to mitigate excessive vertices and/or surfaces in depogrid cells that are non-adjacent to model discontinuities, such as grid boundaries, faults, or unconformities), depogrid cells can be simplified to "hexahedral" type grid cells that are similar to distorted cuboids of structured grid models. For example, a depogrid cell that is non-adjacent to a model discontinuity can include two planar quadrilateral surfaces of each isosurface for a total of six planar quadrilateral surfaces. Each planar quadrilateral surface of those planar quadrilateral surfaces can comprise a set of triangular surfaces. If a set of triangular surfaces comprising a given planar quadrilateral surface is sufficiently co-planar (e.g., within a defined threshold of being co-planar), internal triangularization forming the set of triangular surfaces within the given planar quadrilateral surface can be ignored. In that instance, four boundary vertices of the given planar quadrilateral surface can be used to represent the given planar quadrilateral surface. If a set of triangular surfaces comprising a given planar quadrilateral surface is insufficiently co-planar (e.g., not within a defined threshold of being co-planar), the set of triangular surfaces can be used to represent the given planar quadrilateral surface. In that instance, simplification can be applied to a shared face between two depogrid cells. When viewed in depositional space, such simplified depogrid cells are cuboids whose surfaces are aligned with the orthogonal U, V, and W coordinate directions of depositional space. FIGS. 3A and 3B show an example simplified depogrid cell in depositional space and in geological space, respectively. For ease of reference, reference designator 300 identifies the simplified depogrid cell in depositional space and reference designator 302 identifies the simplified depogrid cell in geological space.

In depositional space, the simplified depogrid cell 300 includes planar quadrilateral surfaces defined at either constant U, V, or W values in (U, V, W) depositional coordinates of depositional space. Specifically, the simplified depogrid cell 300 in depositional space includes two planar quadrilateral surfaces of each isosurface for a total of six planar quadrilateral surfaces. Being non-adjacent to model discontinuities, the simplified depogrid cell 300 can also be represented as a simplified cell when mapped to geological space. A comparison between **FIG. 3A** and **FIG. 3B** shows that, while planar in depositional space, each quadrilateral surface is generally non-planar in geological space. As such, each quadrilateral surface can be represented as two triangles in both depositional space and geological space.

With reference to **FIG. 3C****,** subdividing the simplified depogrid cell 300 can be implemented using a graph structure such as the directional hierarchical acyclic graph structure described above. To that end, a target V value is set to define a V-cutting plane for subdividing the simplified depogrid cell 300 in the V-direction of depositional space. Edge nodes corresponding to the simplified depogrid cell 300 in the graph structure can be evaluated by linear interpolation in depositional space to identify edge nodes that include the target V value. Edge nodes identified as including the target V value can be assigned a crossing label. As described above, each edge node assigned the crossing label is replaced in the graph structure by a new vertex node that is assigned an at-cut label and two new edge nodes. A new vertex node can represent a "crossing point" in depositional space where a corresponding edge node is "crossed" by the V-cutting plane.

Positions of those crossing points in depositional space are identified by circles in **FIG. 3C** to show that new vertex nodes correspond to vertices of a cutting polygon generated for subdividing the simplified depogrid cell 300. A topology defining spatial relationships between the vertices of the cutting polygon can be inherited from an edge-face topology of the simplified depogrid cell 300. Exterior edges of the cutting polygon can be determined using such topology. In **FIG. 3C****,** the exterior edges of the cutting polygon are identified by dot-dot-dash lines joining the vertices of the cutting polygon. As shown by **FIG. 3C****,** the exterior edges of the cutting polygon bound a planar region of depositional space to form a cutting surface of constant V value (e.g., the target V value). A face node representing the cutting surface can be introduced into the graph structure with a cutting-face label being assigned to that face node. Moreover, the cutting polygon generated in depositional space can be mapped to geological space by transforming (U, V, W) depositional coordinates of the vertices in depositional space to (X, Y, Z) geological coordinates of geological space using the dual correspondence between depositional and geological spaces. **FIG. 3C** and **FIG. 3D** show the cutting polygon in depositional and geological spaces, respectively.

As described above, subdividing a depogrid cell in a specific coordinate direction (e.g., a U-direction, a V-direction, or a W-direction) of depositional space also involves triangulation of cutting surfaces represented by face nodes with cutting-face labels such as the face node representing the cutting surface shown in **FIG. 3C****.** A comparison between **FIG. 3C** and **FIG. 3E** shows interior edges that partition the cutting surface into a set of triangular surfaces. In **FIG. 3E****,** those interior edges are identified by dashed lines joining the vertices of the cutting polygon within the exterior edges of the cutting polygon. The set of triangular surfaces formed by triangulation of the cutting surface are shared by two new grid cells generated by subdivision of the simplified depogrid cell 300.

For example, **FIG. 3F** shows depogrid cell 304 and depogrid cell 306 that replace the simplified depogrid cell 302 in geological space following subdivision. In this example, the set of triangular surfaces can be shared by two new depogrid cells in depositional space that correspond to the depogrid cell 304 and depogrid cell 306 in geological space. The set of triangular surfaces generated in depositional space can be mapped to geological space by transforming (U, V, W) depositional coordinates of cutting polygon vertices in depositional space to (X, Y, Z) geological coordinates of geological space using the dual correspondence between depositional and geological spaces. A comparison between **FIG. 3E** and **FIG. 3F** shows that the set of triangular surfaces can form both a planar cutting surface in depositional space and a non-planar cutting surface in geological space.

Planar surfaces of the simplified depogrid cell 300 become planar surfaces of the two new grid cells during subdivision using the graph structure and the shared cutting surface. For example, with reference to **FIG. 3E****,** the simplified depogrid cell 300 includes four triangular planar surfaces that are each parallel with respect to the cutting surface in the V-direction. Being parallel with respect to the cutting surface in the V-direction, none of those four triangular planar surfaces are bifurcated by the cutting surface in subdivision. Each face node representing a triangular planar surface of the simplified depogrid cell 300 that is not bifurcated by the cutting surface in subdivision can be reassigned to a cell node representing a given new depogrid cell during subdivision based on relative positions of the cutting surface and that triangular planar surface in depositional space.

Another example, with reference to **FIG. 3E****,** the simplified depogrid cell 300 includes eight planar surfaces that are orthogonal with respect to the cutting surface that is to be shared by the new grid cells. Those eight planar surfaces include four planar quadrilateral surfaces of the simplified depogrid cell 300 that are each bifurcated into two triangular surfaces. The four planar quadrilateral surfaces include two planar quadrilateral surfaces corresponding to isosurfaces that are parallel in the W-direction. The four planar quadrilateral surfaces also include two planar quadrilateral surfaces corresponding to isosurfaces that are parallel in the U-direction.

**FIG. 3E** shows that each of those eight triangular planar surfaces is bifurcated by the exterior edges of the cutting polygon. As such, prior to subdivision of the simplified depogrid cell 300, the graph structure includes eight face nodes with each bifurcated triangular planar surface being represented in the graph structure by a corresponding face node. During subdivision of the simplified depogrid cell 300, each of those eight face nodes will be replaced in the graph structure by a new edge node and two new face nodes, as described above. A new edge node replacing a given face node in the graph structure during subdivision corresponds to an exterior edge of the cutting polygon that bifurcates a triangular planar surface represented by the given face node. Bifurcation in this instance involves two edges of the triangular planar surface being crossed by the exterior edge of the cutting polygon. The new edge node replacing the given face node in the graph structure automatically includes two new vertex nodes. Each new vertex node represents a point at which the exterior edge of the cutting polygon crosses an edge of the triangular planar surface. The new edge node replacing the given face node is assigned each cell node representing one of the two new grid cells (e.g., grid cells in depositional space that correspond to depogrid cell 304 and depogrid cell 306 in geological space) in depositional space during subdivision.

Two new face nodes replacing a given face node include one new face node that is assigned a below-cut label and another new face node that is assigned an above-cut label. Each of those two new face nodes is assigned to a different new grid cell during subdivision based on relative positions in depositional space. For example, a new face node with a below-cut label can be assigned to a new grid cell in depositional space that corresponds to depogrid cell 304 in geological space. Another example, a new face node with an above-cut label can be assigned to a new grid cell in depositional space that corresponds to depogrid cell 306 in geological space. Each new face node assigned to a new grid cell represents a new planar surface in depositional space that is formed using a portion of a bifurcated triangular planar surface. In **FIG. 3E****,** planar surfaces represented by new face nodes include triangular planar surfaces and planar quadrilaterals. In an embodiment, a planar surface represented by a new face node that is assigned during subdivision can include a higher-order planar polygon, such as a pentagon or a hexagon.

During subdivision, the cell node representing the simplified depogrid cell 300 in the graph structure is replaced by new cell nodes representing the two new grid cells in depositional space that correspond to depogrid cell 304 and depogrid cell 306 in geological space. Various graph nodes (e.g., face nodes, edge nodes, and vertex nodes) can be assigned to each new cell node to generate or create a new depogrid cell in depositional space. Each new depogrid cell generated in depositional space can be mapped to geological space by transforming (U, V, W) depositional coordinates of new depogrid cell vertices in depositional space to (X, Y, Z) geological coordinates of geological space using the dual correspondence between depositional and geological spaces.

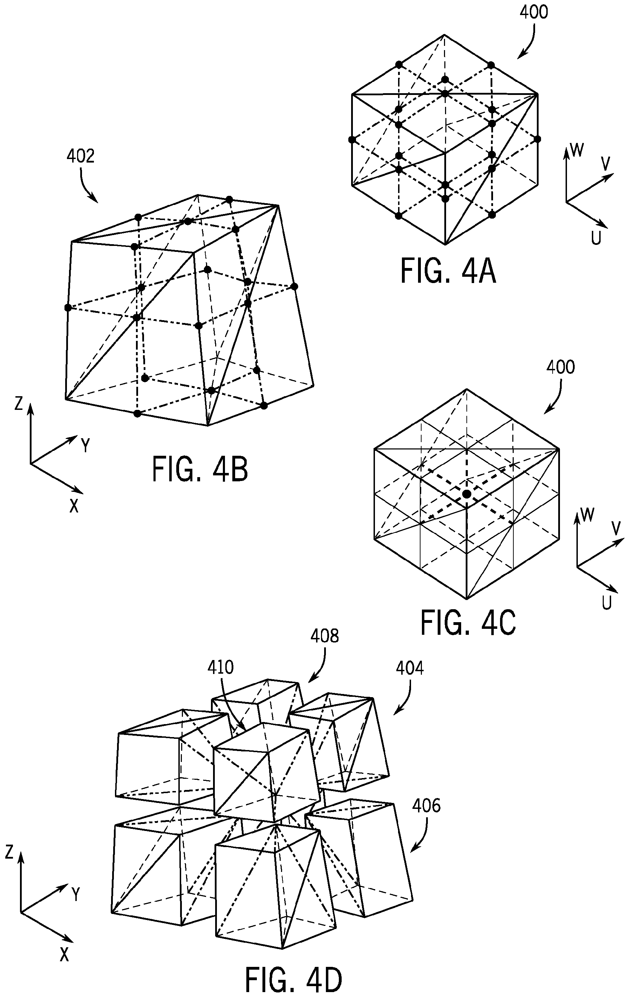

**FIGS. 4A-4D** illustrate multiple subdivisions of a simplified unstructured grid cell, according to one or more embodiments of this disclosure. **FIGS. 4A** and **4B** show an example simplified depogrid cell in depositional space and in geological space, respectively. For ease of reference, reference designator 400 identifies the simplified depogrid cell in depositional space and reference designator 402 identifies the simplified depogrid cell in geological space. Subdivision of the simplified depogrid cell 300 described above with reference **FIGS. 3A-3F** generally represents a single subdivision iteration in depositional space. Subdivision of the simplified depogrid cell 400 described with reference **FIGS. 4A-4D** generally represents multiple subdivision iterations for the simplified depogrid cell 400 in depositional space.

The multiple subdivision iterations for the simplified depogrid cell 400 in depositional space can be implemented using a graph structure such as the directional hierarchical acyclic graph structure described above. With reference to **FIG. 4A****,** one subdivision iteration is applied to the simplified depogrid cell 400 in each coordinate direction of depositional space. Applying one subdivision iteration to the simplified depogrid cell 400 in each coordinate direction of depositional space generates or creates eight new depogrid cells in depositional space. Those eight new depogrid cells can include depogrid cells in depositional space that each correspond to a given depogrid cell (e.g., depogrid cell 404, depogrid cell 406, depogrid cell 408, or depogrid cell 410 of **FIG. 4D**) in geological space.

Each subdivision iteration among the multiple subdivision iterations involves generating or creating a cutting polygon in a specific coordinate direction (e.g., a U-direction, a V-direction, or a W-direction) of depositional space. A cutting polygon can be generated for a given subdivision iteration by setting a target value in the specific coordinate directions of depositional space, as described above with reference to the single subdivision case. Setting the target value defines a cutting plane for the given subdivision iteration. For example, a target U value can be set for the U-direction of depositional space to define a U-cutting plane, a target V value can be set for the V-direction of depositional space to define a V-cutting plane, and/or a target W value can be set for the W-direction of depositional space to define a W-cutting plane. Positions of cutting polygon vertices in depositional space are identified by circles in **FIG. 4A****.** In **FIG. 4A****,** exterior edges of each cutting polygon are identified by dot-dot-dash lines joining corresponding vertices of that cutting polygon on exterior surfaces of the simplified depogrid cell 400. As shown by **FIG. 4A****,** exterior edges of each cutting polygon bound a planar region of depositional space to form cutting surfaces on exterior surfaces of the simplified depogrid cell 400 with each cutting surface having a constant U, V, or W value.

Planar representations of cutting surfaces in depositional space facilitate further subdivision in both depositional and geological spaces of cutting surfaces generated by previous subdivision iterations. For example, **FIG. 4A** shows three subdivision iterations (e.g., one subdivision iteration in each coordinate direction of depositional space) being applied to the simplified depogrid cell 400 in depositional space. Cutting planes associated with each of those three subdivision iterations have a single common intersection point in depositional space that is identified in **FIG. 4C** by a circle. That single common intersection point generates or creates an extra interior vertex located at a center of the simplified depogrid cell 400.

The extra interior vertex can be used to generate or create six new edges (identified by dotted lines in **FIG. 4C**) and 12 new quadrilateral planar cutting surfaces within an interior of the simplified depogrid cell 400. Each new interior cutting surface of those 12 new interior cutting surfaces is aligned with one coordinate direction of depositional space. The example multiple subdivision iteration case represented by **FIGS. 4A-4D** includes a single interior vertex being located at the center of the simplified depogrid cell 400. In other multiple subdivision iteration cases, such as cases involving depogrid cells of greater complexity, interior vertices being located at other positions within a depogrid cell or multiple interior vertices being located within a depogrid cell can be useful. For example, an interior vertex can be located at a non-center position within the interior of the simplified depogrid cell 400 by setting a different target value to define a different cutting plane in at least one subdivision iteration of the multiple subdivision iterations. Another example, one or more additional interior vertices can be located within the interior of the simplified depogrid cell 400 by defining additional cutting planes in at least one coordinate direction of depositional space.

**FIG. 4D** shows the results of triangulation of each interior cutting surface in depositional space after the interior cutting surfaces were transformed to geological space. For example, each of the 12 new interior cutting surfaces were subdivided into a set of interior triangular surfaces (with each set including two triangular surfaces) within an interior of the simplified depogrid cell 400 through triangulation in the depositional space. In **FIG. 4D****,** dot-dot-dash lines identify edges introduced by triangulation of an interior cutting surface to form a set of interior triangular surfaces. In geological space, each set of interior triangular surfaces formed by triangulation of the 12 new interior cutting surfaces in depositional space is shared by two adjacent new depogrid cells that were formed by subdivision in depositional space. For example, **FIG. 4D** shows that depogrid cell 404 shares: a first set of interior triangular surfaces with depogrid cell 406; a second set of interior triangular surfaces with depogrid cell 408; and a third set of interior triangular surfaces with depogrid cell 410. A face-connection topology of each set of interior triangular surfaces can be maintained when transformed from depositional space to geological space. In depositional space, cutting surfaces of new depogrid cells are generally quadrilateral. Such cutting surfaces of new depogrid cells can be represented by sets of interior triangular surfaces formed by triangulation. In some instances, cutting surfaces of new depogrid cells can have different polygonal shapes (e.g., pentagons or hexagons) following subdivision. For example, a cutting surface shared by the depogrid cell 404 and the depogrid cell 410 could be a hexagon if the corresponding V-cutting plane applied to the simplified depogrid cell 400 in **FIG. 4C** extended more than halfway through the simplified depogrid cell 400.

Generally, deferring triangulation of cutting surfaces until all subdivision iterations have been applied to a given simplified grid cell would generate fewer cutting surfaces following subdivision than would have been generated by sequentially triangulating cutting surfaces after each subdivision iteration. Reducing a total number of cutting surfaces generated during subdivision can reduce computational resource utilization by any visualization, simulation, or modeling workflow that consumes an updated depogrid following subdivision. Of note, an equal number of cutting surfaces are produced using either approach in the example illustrated by **FIGS. 4A-4D****.**

A depogrid cell located closely proximate to (e.g., immediately above or below) a conformable horizon can generally be represented as a simplified depogrid cell. If a well top intersection with a conformable horizon occurs on a surface of a depogrid cell located closely proximate to that horizon, that intersection point can be represented precisely as a vertex of the depogrid cell. Depogrid cells with surfaces that include vertices representing such intersection points can be distorted and/or concave as triangulation of those surfaces can produce complex triangulated surfaces. Depogrid cells with such distortion or concavity associated with well top intersection can be considered non-simplified depogrid cells.

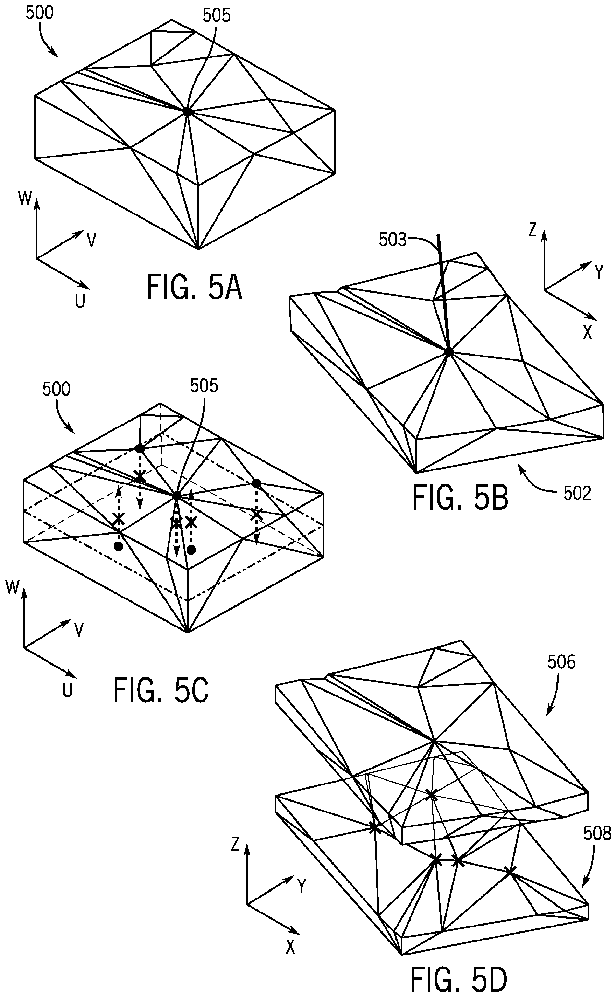

**FIGS. 5A-5D** illustrate subdivision of a non-simplified depogrid cell at a well top, according to one or more embodiments of this disclosure. **FIGS. 5A and 5B** show an example depogrid cell at the well top in depositional space and in geological space, respectively. For ease of reference, reference designator 500 identifies the depogrid cell in depositional space and reference designator 502 identifies the depogrid cell in geological space. In **FIG. 5B****,** reference designator 503 corresponds with a solid line substantially oriented in the Z-direction of geological space. That solid line corresponding with reference designator 503 identifies the well. In **FIG. 5B****,** the well 503 intersects a surface (e.g., an upper surface) of the depogrid cell 502 that is against a conformable horizon. In an embodiment, a precise intersection point between the well 503 and the conformable horizon defines a well top point to be precisely represented within the depogrid cell geometry in geological space.

In **FIG. 5A****,** the depogrid cell 500 in depositional space includes a surface that corresponds to the surface of the depogrid 502 in geological space that is against the conformable horizon. Reference designator 505 corresponds with a circle located on that surface of the depogrid cell 500 in depositional space. That circle corresponding with reference designator 505 identifies a well top vertex. The well top vertex 505 is a depositional space representation of the well top intersection point on the surface of the depogrid cell 502 in geological space. Accurately representing a relative location of the well top intersection point in depositional space using the well top vertex 505 introduces an additional constraint for subdividing the depogrid cell 500 in depositional space.

**FIG. 5A** shows that the depogrid cell 500 in depositional space is generally a cuboid formed by multiple planar quadrilateral surfaces that are each defined at a constant value in a given coordinate direction of depositional space. Each planar quadrilateral surface of the depogrid cell 500 is represented as a set of triangular surfaces. Each triangular surface in a given set of triangular surfaces is defined at the same constant value as the corresponding planar quadrilateral surface. The depogrid cell 500 includes two planar quadrilateral surfaces in the W-direction: a first planar quadrilateral surface in the W-direction ("upper W-surface") that includes the well top vertex 505; and a second planar quadrilateral surface in the W-direction ("lower W-surface") that does not include the well top vertex 505. Presence of the well top vertex 505 on the upper W-surface of the depogrid cell 500 increases complexity of both the upper and lower W-surfaces of the depogrid cell 500. Preexisting internal vertices on the upper and lower W-surfaces of the depogrid cell 500 can be used to generate additional control points on a W-cutting surface during subdivision to maintain an accurate representation of the W-cutting surface. Planar quadrilateral surfaces of the depogrid cell 500 in both the U-direction and the V-direction of depositional space lack any preexisting internal vertices. Additional control points are not needed on a U-cutting surface or on a V-cutting surface during subdivision to maintain accurate representations of those cutting surfaces.

Subdivision of the non-simplified depogrid cell 500 in depositional space can be implemented using a graph structure such as the directional hierarchical acyclic graph structure described above. With reference to **FIG. 5C****,** subdivision of the depogrid cell 500 involves generating a cutting polygon in the W-direction of depositional space. In **FIG. 5C****,** exterior edges of the cutting polygon are identified by dot-dot-dash lines that circumscribe surfaces of the depogrid cell 500 that are parallel to the U-W and V-W planes of depositional space. The cutting polygon for subdividing the depogrid cell 500 can be generated by setting a target value in the W-direction of depositional space to define a W-cutting plane, in a similar manner as described above with reference to the other subdivision cases.

In subdivision cases involving depogrid cells with well top-conformable horizon intersections, cutting surfaces that are planar in depositional space may become substantially non-planar in geological space. This is especially true as parallel surfaces of such depogrid cells become increasingly distorted in a given coordinate direction of depositional space. In such instances, a cutting surface (e.g., the W-cutting surface defined for the depogrid cell 500) should be maintained between parallel surfaces of a depogrid in a given coordinate direction of depositional space throughout a volume of the depogrid. Otherwise, the cutting surface may intersect one or more of those parallel surfaces.

Defining a cutting surface with a cutting polygon and additional control points can be useful to mitigate intersection of the cutting surface with one or more surfaces of a depogrid cell when transformed to geological space. One constraint involved in defining locations of additional control points for the cutting surface is that each additional control point should be located within a region of a cutting plane that is bounded by the cutting polygon to define the cutting surface. Position information in (X, Y, Z) geological coordinates of geological space for each geological space representation of a given parallel surface present another constraint that is involved in defining locations of additional control points for the cutting surface. For example, a position of an additional control point in (X, Y, Z) geological coordinates of geological space should be defined to remain between opposing surfaces of the depogrid cell in geological space. While observing such constraints, control points can be defined along any ray passing through a depogrid cell in depositional space when that ray includes a starting point that is fixed to either a surface of the depogrid cell with a well top vertex (e.g., the well top vertex 505) or the surface of the depogrid cell that runs parallel to that surface. In an embodiment, increasing a number of additional control points used to define a cutting surface for subdividing a depogrid cell with a well top vertex increases an accuracy of the cutting surface between new depogrid cells when the cutting surface is transformed to geological space.

**FIG. 5C** shows five rays being used to generate five additional control points. In **FIG. 5C****,** each control point is identified by a cross or an "X". Each ray that generates a given control point is identified in **FIG. 5C** by a dotted arrow that extend orthogonally from the upper W-surface or the lower W-surface of the depogrid cell 500. Each ray in **FIG. 5C** intersects both a W-cutting plane defined by a target W value in the W-direction of depositional space and a triangular surface within an opposing W-surface of the depogrid cell 500. For example, a ray that is fixed to a point (U, V, Wᵤₚₚₑᵣ) on the upper W-surface of the depogrid cell 500 intersects a point (U, V, W_{cut}) on the W-cutting plane and a triangular surface (T_{lower}) within the lower W-surface at a point (U, V, W_{lower}). In an embodiment, a depositional space location of the point (U, V, W_{lower}) within the triangle T_{lower} can be represented using Barycentric coordinates. In an embodiment, a geological space location of a point corresponding to the point (U, V, W_{lower}) can be estimated using (X, Y, Z) coordinates of triangle T_{lower} vertices in geological space when the depositional space location of the point (U, V, W_{lower}) is represented using Barycentric coordinates. The geological space location of a point corresponding to the point (U, V, W_{cut}) on the W-cutting plane can be estimated using linear interpolation along the corresponding ray.

Another example, a ray that is fixed to a point (U, V, W_{lower}) on the lower W-surface of the depogrid cell 500 intersects a point (U, V, W_{cut}) on the W-cutting plane and a triangular surface (Tᵤₚₚₑᵣ) within the upper W-surface at a point (U, V, Wᵤₚₚₑᵣ). In an embodiment, a depositional space location of the point (U, V, Wᵤₚₚₑᵣ) within the triangle Tᵤₚₚₑᵣ can be represented using Barycentric coordinates. The geological space location of a point corresponding to the point (U, V, Wᵤₚₚₑᵣ) can be estimated using (X, Y, Z) geological coordinates of triangle Tᵤₚₚₑᵣ vertices in geological space when the depositional space location of the point (U, V, Wᵤₚₚₑᵣ) is represented using Barycentric coordinates. The geological space location of a point corresponding to the point (U, V, W_{cut}) on the W-cutting plane can be estimated using linear interpolation along the corresponding ray.

Each point (U, V, W_{cut}) on the W-cutting plane where a given ray intersects the W-cutting plane can be considered an additional control point for defining a W-cutting surface if two constraints are satisfied. The first constraint is that a depositional space location of the point (U, V, W_{cut}) is within a region of the W-cutting plane that the cutting polygon (identified by dot-dot-dash lines that circumscribe surfaces of the depogrid cell 500 that are parallel to the U-W and V-W planes of depositional space) bounds to define the W-cutting surface. In an embodiment, the first constraint can define a filter that excludes any point (U, V, W_{cut}) on the W-cutting plane with a depositional space location that is external to the region of the W-cutting plane to define the W-cutting surface. Instances where a point (U, V, W_{cut}) has a depositional space location that is external to the region of the W-cutting plane that the cutting polygon bounds generally involve distorted depogrid cells or concave cutting polygons. The second constraint is that a geological space location of the point (U, V, W_{cut}) is between geological space locations where a corresponding ray intersects the upper and lower W-surfaces of the depogrid cell 500.

A planar W-cutting surface for subdividing the depogrid cell 500 in depositional space can be defined by the cutting polygon and additional control points provided by each point (U, V, W_{cut}) on the W-cutting plane that satisfies both constraints. Triangulation of the W-cutting surface can occur in depositional space before the W-cutting surface is transformed to geological space using vertices of the cutting polygon, the additional control points, and a correspondence mapping between depositional space and geological space. In an embodiment, triangulation can be implemented using constrained Delaunay triangulation. **FIG. 5D** shows that, when transformed to geological space, the W-cutting surface defined using the cutting polygon and the additional control points provides common intermediate surfaces between new depogrid cells 506 and 508 that are formed by subdividing depogrid cell 502. In an embodiment, self-intersection quality checks on the new depogrid cells 506 and 508 can be employed to ensure that a topography of each intermediate surface is sufficiently controlled. **FIG. 5D** also shows that, when transformed to geological space, the W-cutting surface defined using the cutting polygon and the additional control points has a more complex triangulated form than the cutting surfaces described above with reference to **FIGS. 3A-3F** and **FIGS. 4A-4D****.**

**FIGS. 5A and 5C** show the depogrid cell 500 as being cuboidal in depositional space because the depogrid cell 502 was adjacent to a conformable horizon in geological space. If the depogrid cell 502 was adjacent to an unconformable horizon in geological space, then the depogrid cell 500 would not be cuboidal in depositional space. For example, as discussed above with reference to **FIG. 2****,** depogrid cells that are adjacent to model discontinuities (e.g., faults) can represented as cut cells. In (X, Y, Z) geological coordinates of geological space, depogrid cells adjacent to model discontinuities generally comprise planar faces (e.g., triangles, quadrilaterals, and the like) forming complex polyhedra that can be convex or concave. In (U, V, W) depositional coordinates of depositional space, depogrid cells represented by cut cells are part of a simpler cuboid representation, and we take advantage of this simpler representation when generating planar cutting surfaces with constant U, V or W values.

The foregoing disclosure with reference to **FIGS. 5A-5D** generally describes an approach for generating additional control points to define cutting surfaces for subdividing non-simplified depogrid cells in depositional space. As described above with reference to **FIGS. 5A-5D****,** cutting surfaces for subdividing non-simplified depogrid cells can be significantly non-planar in geological space. Such non-planarity can relate to non-planarity of a corresponding cutting polygon in geological space. Such non-planarity can also relate to maintaining cutting surfaces between adjacent upper and lower surfaces of the parent non-simplified depogrid cell throughout a volume of that depogrid cell in geological space.

Surface complexity of adjacent upper and/or lower surfaces can be a relevant factor to consider when determining a number of additional control points to use for maintaining a cutting surface between those surfaces throughout a volume of the parent non-simplified depogrid cell in geological space. Existing vertices on the adjacent upper and/or lower surfaces likely correspond to locations on those surfaces that are associated with more rapid surface orientation changes. Locations of such existing vertices can be used to generate a subset (e.g., a minimum number of additional control points) of additional control points. For example, a vertex of a parent non-simplified depogrid cell can be used as an additional control point to define a cutting surface when the vertex corresponds to a surface that has the same face type as the cutting surface. In accordance with this example, a vertex on an upper or lower V-surface of a parent non-simplified depogrid cell can be used as an additional control point to define a V-cutting surface for subdividing that depogrid cell.

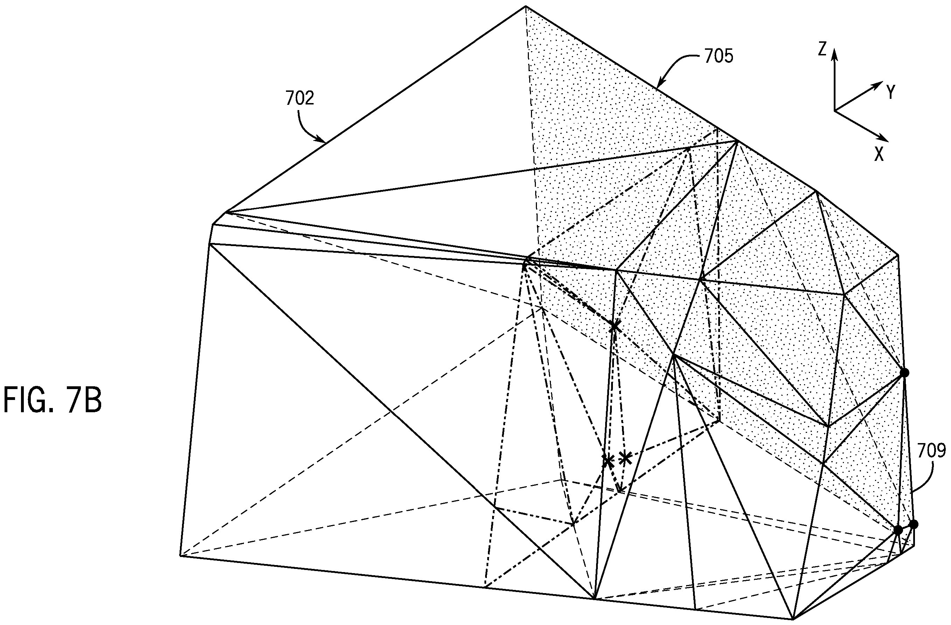

Vertices on an edge of a surface with the same face type as a cutting surface are generally not useful as additional control points to define the cutting surface unless that edge corresponds to a grid discontinuity surface. An embodiment discussed in greater detail below with reference to **FIG. 7B** provides an example in which vertices on an edge of a U-surface of a parent non-simplified depogrid cell can be used as additional control points to define a U-cutting surface. In that embodiment, vertices on a portion of the edge where the U-surface interfaces with a fault face are used as additional control points to define the U-cutting surface. In that embodiment, vertices on other portions of that edge are not used as additional control point to define the U-cutting surface, such as vertices on a portion of the edge where the U-surface joins to a V-surface or a W-surface of the parent non-simplified depogrid cell.

Additional control points for defining a cutting surface can be generated at selected locations of upper and/or lower surfaces of a parent non-simplified depogrid cell that are identified as being adjacent to the cutting surface being generated. Generating additional control points for defining a cutting surface involves defining rays at the selected locations where the rays are orthogonal to the cutting surface. Each ray is fixed to either the upper surface or the lower surface that is identified as adjacent to the cutting surface being generated. Such rays intersect the upper and lower surfaces that are identified as adjacent to the cutting surface being generated at two intersection points. One of the two points at which a given ray intersects the upper and lower surfaces that are identified as adjacent to the cutting surface can be an original vertex of a corresponding surface.

A position of each point at which a given ray intersects the upper and lower surfaces in (U, V, W) depositional coordinates of depositional space are known. Values for two of the three coordinate directions (e.g., non-cutting directions) of depositional space are constant along the given ray. A value for the remaining coordinate direction, a cutting direction, at each point is the value of the upper surface or the lower surface in the cutting direction. A position of a control point (a point at which a given ray intersects a cutting surface) in (U, V, W) depositional coordinates of depositional space can then be determined using the known positions at which the given ray intersects the upper and lower surfaces in depositional space. A position of each point at which a given ray intersects the upper and lower surfaces in (X, Y, Z) coordinates of geological space can be determined using Barycentric (U, V, W) depositional coordinates within a triangular surface on each respective surface that the given ray intersects. A position of a control point (a point at which a given ray intersects a cutting surface) in (X, Y, Z) geological coordinates of geological space can be determined by applying linear interpolation between respective positions in (X, Y, Z) geological coordinates of each point at which the given ray intersects the upper and lower surfaces.

A cutting polygon bounds a planar region of a cutting plane in depositional space that includes additional control points to define a cutting surface. Triangulation can occur in depositional space before that cutting surface is transformed to geological space using vertices of the cutting polygon, the additional control points, and a correspondence mapping between depositional space and geological space. In an embodiment, triangulation can be implemented using constrained Delaunay triangulation. When transformed to geological space, respective positions of cutting polygon vertices and additional control points in (X, Y, Z) geological coordinates of geological space can be used to define a geometry of the cutting surface in geological space. In geological space, the cutting surface has a triangulated surface topology that is the same or substantially similar to a triangulated surface topology of the cutting surface in depositional space. The cutting surface provides common intermediate surfaces between child depogrid cells formed by subdividing a parent non-simplified depogrid cell in depositional space using the cutting surface. Each intermediate surface that the cutting surface provides to a given child depogrid cell has a face assignment that is consistent with a cutting direction of the cutting surface. For example, each intermediate surface that a cutting surface provides to a given child depogrid cell can have a W-type face assignment when a cutting direction of the cutting surface is in the W-direction of depositional space. Subdivisions that occur subsequent to application of the cutting surface to the parent non-simplified depogrid cell can be iteratively applied to child depogrid cells until all subdivisions have occurred.

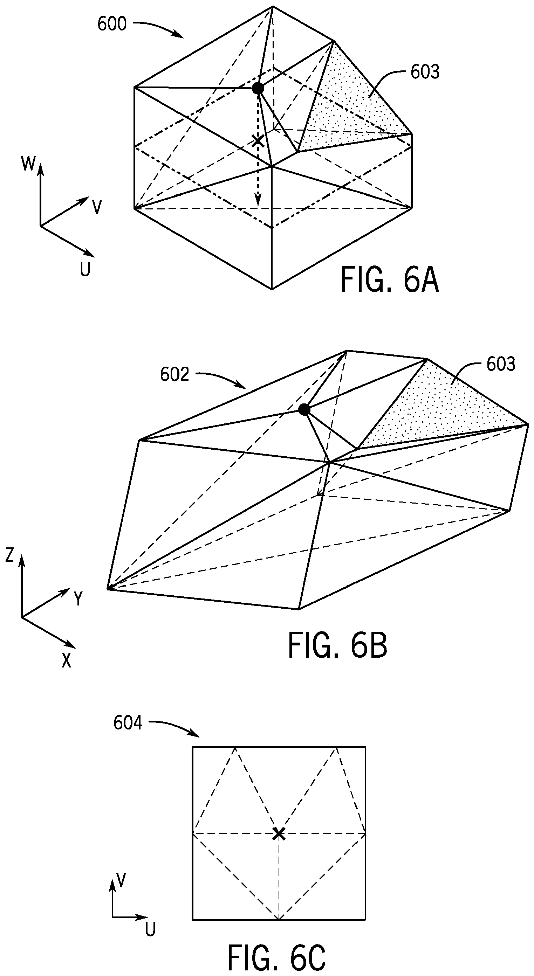

**FIGS. 6A-6C** illustrate subdivision of a non-simplified depogrid cell at an unconformity, according to one or more embodiments of this disclosure. **FIGS. 6A and 6B** show an example depogrid cell at the unconformity in depositional space and in geological space, respectively. For ease of reference, reference designator 600 identifies the depogrid cell in depositional space and reference designator 602 identifies the depogrid cell in geological space. Subdivision of the non-simplified depogrid cell 600 in depositional space can be implemented using a graph structure such as the directional hierarchical acyclic graph structure described above. As discussed above, **FIGS. 5A** and **5C** show the depogrid cell 500 as being cuboidal in depositional space because the depogrid cell 502 shown by **FIG. 5B** was adjacent to a conformable horizon in geological space. If the depogrid cell 502 of **FIG. 5B** was adjacent to an unconformable horizon in geological space, **FIGS. 5A** and **5C** could not show the depogrid cell 500 as being cuboidal in depositional space.

In **FIG. 6B****,** reference designator 603 corresponds to a shaded surface of the depogrid cell 602 in geological space. That shaded surface corresponding with reference designator 603 identifies an unconformity. With the depogrid cell 602 being adjacent to the unconformity 603 in geological space, **FIG. 6A** cannot show the depogrid cell 600 as being a cuboid in depositional space. Rather, **FIG. 6A** shows the depogrid cell 600 as a cuboid in depositional space that has been cut by a triangulated surface corresponding to the unconformity 603 that is adjacent to the depogrid cell 602 in geological space. A sibling cell encompassing a volume of depositional space that combines with the depogrid cell 600 to form a cuboid in depositional space does not exist in a depogrid that includes the depogrid cell 600.

**FIG. 6B** shows that the depogrid cell 602 includes some surfaces (e.g., a surface having a depositional representation that is parallel to a U-W plane in depositional space) that are represented in geological space using simplified quadrilateral surfaces composed of two triangular sub-surfaces. **FIG. 6B** also shows that other surfaces (e.g., a surface that is proximate to the unconformity 603 and having a depositional space representation that is parallel to a U-V plane in depositional space) at or near the unconformity 603 of the depogrid cell 602 are represented in geological space using surfaces that are more complex than simplified quadrilateral surfaces composed of two triangular sub-surfaces. Increased complexity of depogrid cell surfaces at or near the unconformity 603 can increase a likelihood of intersection between such depogrid cell surfaces and a cutting surface for subdividing the depogrid cell. The cutting surface can also be increasingly non-planar in geological space because of such increased complexity of depogrid cell surfaces at or near the unconformity 603. In such instances, additional control points can be generated to further define the cutting surface.

To that end, a cutting polygon can be generated by setting a target value in the W-direction of depositional space to define a W-cutting plane, in a similar manner as described above with reference to the other subdivision cases. With reference to **FIG. 6A****,** the depogrid cell 600 includes two planar quadrilateral surfaces in the W-direction: a first planar quadrilateral surface in the W-direction ("upper W-surface") that corresponds to a surface of the depogrid cell 602 in geological space that is proximate to the unconformity 603; and a second planar quadrilateral surface in the W-direction ("lower W-surface") that opposes the upper W-surface. **FIG. 6A** shows that the upper W-surface includes an edge that interfaces with the unconformity 603. In **FIG. 6A****,** edges of the cutting polygon are identified by dot-dot-dash lines that circumscribe surfaces of the depogrid cell 600 that are orthogonal to the upper and lower W-surfaces. With reference to **FIG. 6C****,** that cutting polygon bounds a planar region of the W-cutting plane with the target value in the W-direction of depositional space to define a W-cutting surface 604. The W-cutting surface 604 includes an additional control point that is identified by a cross or an "X" in **FIG. 6C. FIG. 6A** shows a ray being used to generate the additional control point to define the W-cutting surface 604. The ray is identified in **FIG. 6A** by a dotted arrow that extends orthogonally from the upper W-surface of the depogrid cell 600. **FIG. 6A** shows that the ray is fixed to a vertex on the upper W-surface that is remote from the edge of the upper W-surface that interfaces with the unconformity 603.

**FIG. 6A** shows that the ray intersects both a region of the W-cutting plane that is bound by the cutting polygon to define the W-cutting surface 604 and a triangular surface within the lower W-surface of the depogrid cell 600. Specifically, the ray is fixed to a point (U, V, Wᵤₚₚₑᵣ) on the upper W-surface of the depogrid cell 600, intersects a point (U, V, W_{cut}) on the W-cutting surface 604, and also intersects a triangular surface (T_{lower}) within the lower W-surface at a point (U, V, W_{lower}). Depositional space locations of each point (e.g., the point (U, V, Wᵤₚₚₑᵣ) on the upper W-surface, the point (U, V, W_{lower}) on the lower W-surface, and the point (U, V, W_{cut}) on the W-cutting surface 604) in depositional space and geological space locations of each corresponding point in geological space can be determined, in a similar manner as described above with reference to **FIGS. 5A-5D****.** In an embodiment, a well (e.g., the well 503 of **FIG. 5B**) can intersect a surface of the depogrid cell 602 that is at or near the unconformity 603 in geological space. In this embodiment, a well top vertex (e.g., the well top vertex 505 of **FIGS. 5A** and **5C**) representing the well top in depositional space can be used to generate an additional control point to define the W-cutting surface 604, in a similar manner as described above with reference to **FIGS. 5A-****5D.**

**FIG. 6C** shows that triangulation can occur in depositional space before the W-cutting surface 604 is transformed to geological space. Triangulation of the W-cutting surface 604 can be implemented using vertices of the cutting polygon, the additional control point, and a correspondence mapping between depositional space and geological space. A triangulated surface topology of the W-cutting surface 604 can define a topology of a corresponding cutting surface representation in geological space. The corresponding cutting surface representation in geological space provides common intermediate surfaces between child depogrid cells formed by subdividing the parent non-simplified depogrid cell 600 in depositional space using the W-cutting surface 604.

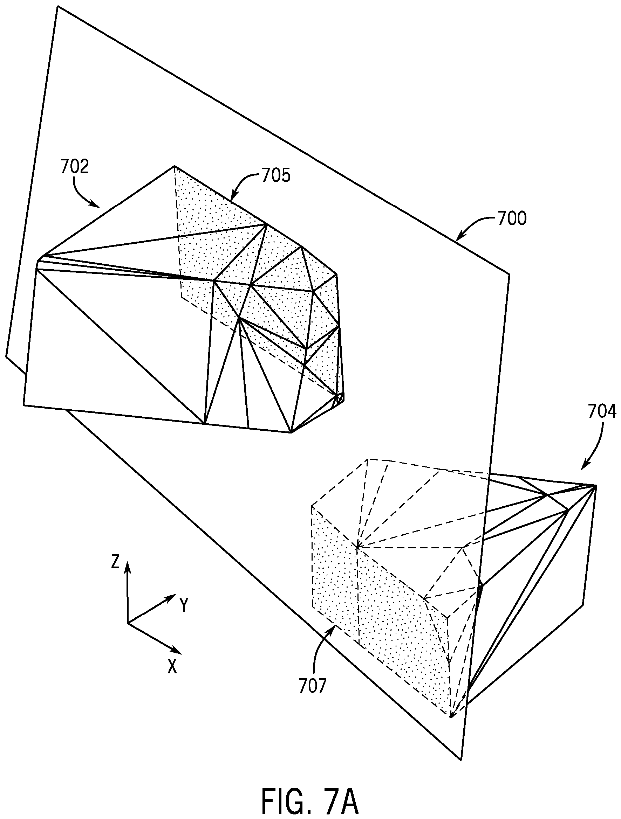

**FIGS. 7A-7C** illustrate subdivision of a non-simplified depogrid cell at a fault, according to one or more embodiments of this disclosure. In **FIG. 7A****,** reference designator 700 corresponds to a shaded surface in geological space. That shaded surface corresponding with reference designator 700 identifies a fault that separates a depogrid cell 702 from a depogrid cell 704 in geological space. Depositional space representations of the depogrid cell 702 and the depogrid cell 704 can be sibling depogrid cells that combine to form a cuboid depogrid cell in depositional space. A depositional space representation of the fault 700 can fully cut through the cuboid depogrid cell formed by combining those sibling depogrid cells in depositional space.

In **FIG. 7A****,** reference designator 705 and reference designator 707 correspond to shaded surfaces of the depogrid cell 702 and the depogrid cell 704, respectively, in geological space. The shaded surface corresponding with reference designator 705 identifies a surface of the depogrid cell 702 that interfaces with a first side of the fault 700 in geological space. The shaded surface corresponding with reference designator 707 identifies a surface of the depogrid cell 704 that interfaces with a second side of the fault 700 in geological space. The first side of the fault 700 that interfaces with the surface 705 and the second side of the fault 700 that interfaces with the surface 707 can be opposite sides of the fault 700 in geological space. The surface 705 of the depogrid cell 702 can have a face assignment corresponding to the fault 700 and the first side of the fault 700 at which the depogrid cell 702 interfaces with the fault 700. The surface 707 of the depogrid cell 704 can have a face assignment corresponding to the fault 700 and the second side of the fault 700 at which the depogrid cell 704 interfaces with the fault 700.

With reference to **FIG. 7B****,** a cutting surface can be defined to subdivide a depositional space representation of the depogrid cell 702 in a specific coordinate direction of depositional space. To that end, a cutting polygon can be generated by setting a target value in the U-direction of depositional space to define a U-cutting plane, in a similar manner as described above with reference to the other subdivision cases. Subdivision of the depositional space representation of the depogrid cell 702 in depositional space can be implemented using a graph structure such as the directional hierarchical acyclic graph structure described above. In **FIG. 7B****,** edges of the cutting polygon, as transformed to geological space, are identified by dot-dot-dash lines that circumscribe exterior surfaces of the depogrid cell 702 in geological space. In depositional space, that cutting polygon can bound a planar region of the U-cutting plane with the target value in the U-direction of depositional space to define a U-cutting surface.

Additional control points can be generated in depositional space to further define the U-cutting surface, in a similar manner as described above with reference to the other subdivision cases. A geological space representation of each additional control point is identified by a cross or an "X" in **FIG. 7B****.** A depositional space representation of the depogrid cell 702 can include two planar quadrilateral surfaces ("U-surfaces") in the U-direction of depositional space. In depositional space, specific vertices on a first U-surface of that depositional space representation of the depogrid cell 702 can be selected to provide fixed starting points on the first U-surface for rays to generate each additional control point. A geological space representation of each vertex selected on the first U-surface to provide a fixed starting point for a ray to generate an additional control point is identified by a circle in FIG. 7B.

In **FIG. 7B****,** reference designator 709 corresponds to an edge that is positioned between the surface 705 and a surface of the depogrid cell 702 that corresponds to the first U-surface. The edge corresponding to reference designator 709 identifies a geological space representation of an edge in depositional space between the first U-surface and a depositional space representation of a depogrid cell surface that interfaces with the fault 700. FIG. 7B shows that some additional control points can be generated from vertices positioned on the edge in depositional space between the first U-surface and the depogrid cell surface 705 that interfaces with the fault 700.

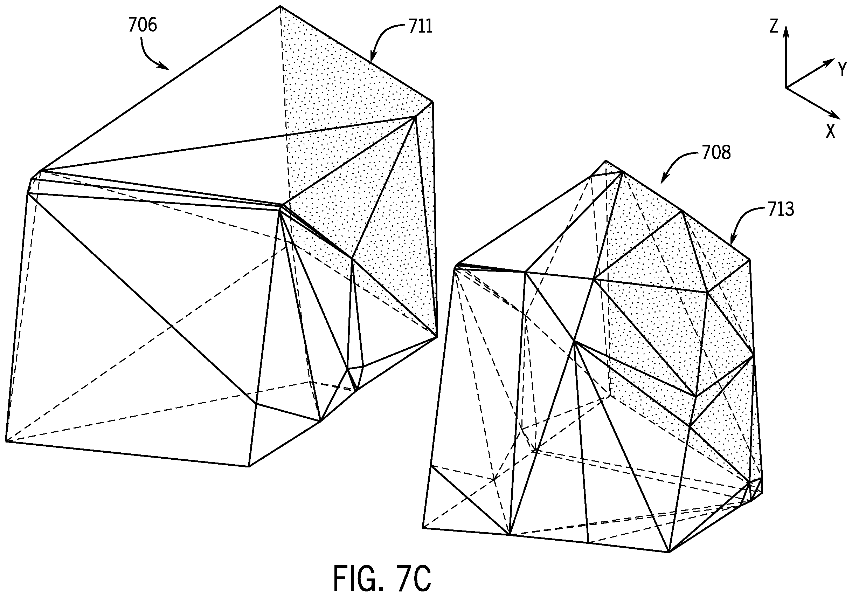

Triangulation can occur in depositional space before the U-cutting surface is transformed to geological space. Triangulation of the U-cutting surface can be implemented using vertices of the cutting polygon, the additional control points, and a correspondence mapping between depositional space and geological space, in a similar manner as described above with reference to the other subdivision cases. Application of the U-cutting surface to a depositional space representation of the depogrid cell 702 forms child depogrid cells in depositional space that correspond to a depogrid cell 706 and a depogrid cell 708 of **FIG. 7C. FIG. 7C** shows that a geological space representation of the U-cutting surface provides common intermediate surfaces between the depogrid cell 706 and the depogrid cell 708 in geological space.

**FIG. 7C** also shows that other surfaces of a parent depogrid cell (e.g., a depositional space representation of the depogrid cell 702 of **FIGS. 7A** and **7B**) are also subdivided by the U-cutting surface in depositional space. For example, the surface 705 of the depogrid cell 702 that interfaces with the fault 700 has been subdivided into a surface 711 of the depogrid cell 706 and a surface 713 of the depogrid cell 708 in **FIG. 7C****.** As shown by **FIG. 7B****,** the surface 705 of the depogrid cell 702 is represented by planar polygons. With the surface 705 of the depogrid cell 702 being represented by planar polygons, the surface 711 and the surface 713 are already represented by planar polygons. As such, re-triangulation of the surface 711 and the surface 713 is unnecessary following subdivision.

**FIGS. 8A-8C** illustrate subdivision of a non-simplified depogrid cell that represents a dying fault cell, according to one or more embodiments of this disclosure. As described above with reference to **FIG. 7A****,** some depositional space representations of faults can fully cut through a depogrid cell in depositional space. In some instances, a fault may not fully cut through a depogrid cell in depositional space. Such instances can occur within a depogrid where a fault tip loop exists. A fault tip loop exists within a depogrid where one fault does not terminate against another fault in the depogrid. In such instances where a fault does not fully cut through a depogrid cell in depositional space, the depogrid cell can represent a dying fault cell if no other faults or unconformities cut through that depogrid cell. A dying fault cell includes a first surface that interfaces with a first side of a fault and a second surface that interfaces with a second side of the fault. Those first and second sides of the fault can represent opposing sides of the fault in geological space. Both sides of the same fault occur as face assignments of the dying fault cell via respective face assignments of the first and second surfaces of the dying fault cell. One skilled in the art will recognize that the preceding description represents one example of a dying fault cell. Other examples of dying fault cells exist. For example, the preceding example dying fault cell could also include a third surface that shares an edge with the first surface or the second surface. In this example, the third surface could, at least, partially interface with an unconformity.

**FIG. 8A** shows a fault 800 that does not fully cut through a depogrid cell 802 in geological space. No other faults (besides the fault 800) or unconformities cut through the depogrid cell 802 of **FIG. 8A****.** In **FIG. 8A****,** reference designator 803 and reference designator 805 correspond with a first shaded surface and a second shaded surface of the depogrid cell 802 in geological space, respectively. The shaded surface corresponding with reference designator 803 identifies a surface of the depogrid cell 802 that interfaces with a first side of the fault 800 in geological space. The shaded surface corresponding with reference designator 805 identifies a surface of the depogrid cell 802 that interfaces with a second side of the fault 800 in geological space. Both sides of the same fault - the fault 800 - occur as face assignments of the depogrid cell 802 via respective face assignments of the first surface 803 and the second surface 805 of the depogrid cell 802. Depogrid cell 802 of **FIG. 8A** is an example of a dying fault cell in geological space.

**FIG. 8A** shows that, as a dying fault cell, the depogrid cell 802 can closely approximate a cuboidal shape in geological space. The first surface 803 partially defines a first portion of the depogrid cell 802 that encompasses a first volume of geological space. The second surface 805 partially defines a second portion of the depogrid cell 802 that encompasses a second volume of geological space. In geological space, those first and second volumes of geological space encompassed by the first and second portions of the depogrid cell 802 are spatially separated by the fault 800. A depositional space representation of the depogrid cell 802 can have a substantially cuboidal shape. Outer surfaces (e.g., surfaces of the depogrid cell 802 forming a periphery of the depogrid cell 802 with the first surface 803 and the second surface 805) of the depogrid cell 802 can map to corresponding surfaces of the depositional space representation of the depogrid cell 802. The fault 800 can be represented in depositional space as a partial slice through the depositional space representation of the depogrid cell 802. In depositional space, the partial slice representing the fault 800 introduces little to no spatial offset between portions of the depositional space representation of the depogrid cell 802 positioned on opposing sides of that partial slice.

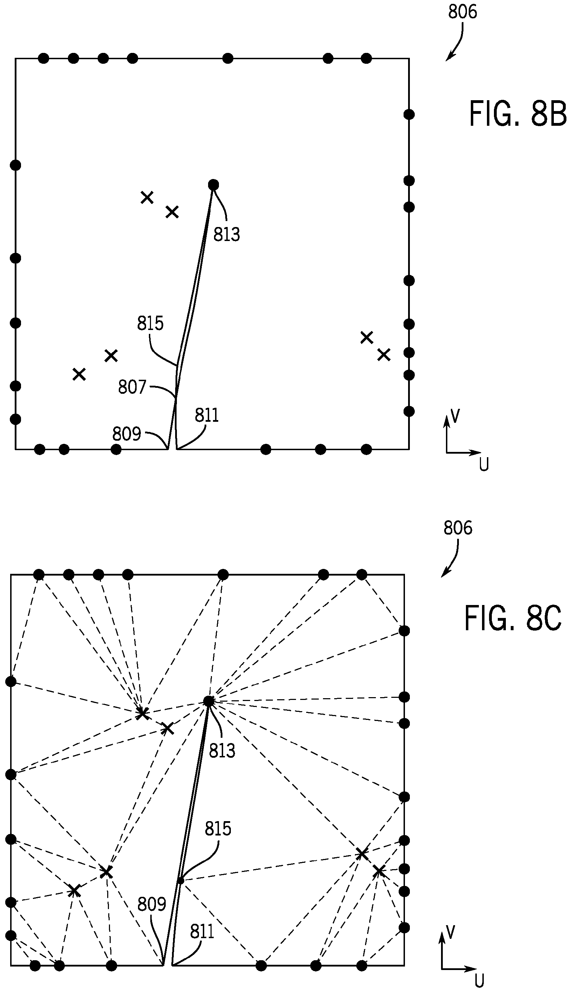

For example, **FIGS. 8B** and **8C** show an example of a cutting surface - a W-cutting surface 806 - that can be defined to subdivide the depositional space representation of the depogrid cell 802 in the W-direction of depositional space. Subdivision of the depositional space representation of the depogrid cell 802 in depositional space can be implemented using a graph structure such as the directional hierarchical acyclic graph structure described above. The fault 800 is represented in **FIGS. 8B** and **8C** as a partial slice through the W-cutting surface 806. As shown by **FIGS. 8B** and **8C****,** the partial slice representing the fault 800 in depositional space introduces little to no spatial offset between portions of the W-cutting surface 806 that are positioned on opposing sides of that partial slice.

The W-cutting surface 806 can be defined, in a similar manner as described above with reference to the other subdivision cases, by setting a target value in the W-direction of depositional space to generate a cutting polygon. In depositional space, the cutting polygon can bound a planar region of the W-cutting plane with the target value in the W-direction of depositional space to define the W-cutting surface 806. In **FIG. 8A****,** edges of the cutting polygon, as transformed to geological space, are represented by dot-dot-dash lines (identified by reference designator 817) that partition the first surface 803 and the second surface 805. The cutting polygon that defines the W-cutting surface 806 is a first cutting polygon of three cutting polygons that are shown by **FIG. 8A. FIG. 8A** shows that a first edge of the first cutting polygon (that defines the W-cutting surface 806 in depositional space) partitions the first surface 803 and a second edge of the first cutting polygon partitions the second surface 805.

A second cutting polygon and a third cutting polygon shown by **FIG. 8A** correspond to subdivisions of the depositional space representation of the depogrid cell 802 using a V-cutting plane. Edges of the second cutting polygon, as transformed to geological space, are represented by dot-dot-dash lines (identified by reference designator 821) that partition the first surface 803. Edges of the third cutting polygon, as transformed to geological space, are represented by dot-dot-dash lines (identified by reference designator 819) that partition the second surface 805. The second and third cutting polygons can each be generated by setting a target value in the V-direction of depositional space. The second cutting polygon can bound a first planar region of the V-cutting plane having the target value in the V-direction of depositional space to define a first V-cutting surface that subdivides a depositional space representation of the first surface 803. The third cutting polygon can bound a second planar region of the V-cutting plane having the target value in the V-direction of depositional space to define a second V-cutting surface that subdivides a depositional space representation of the second surface 805.

The first and second sides of the fault 800 each interface with multiple depogrid cells in geological space. Each side of the fault 800 corresponds to an independent fault surface that is formed by an aggregate of all depogrid cell surfaces that interface with that side of the fault 800. Those independent surfaces each have different geometries (e.g., different vertices and/or different faces). In geological space, those independent surfaces with different geometries can be geometrically matching. In depositional space, those independent surfaces with different geometries may not be geometrically matching. For example, reference designator 807 of **FIG. 8B** corresponds to a position within the W-cutting plane 806 where a depositional space representation of the first surface 803 intersects with a depositional space representation of the second surface 805. As described above with reference to **FIG. 8A**, a first edge of the first cutting polygon (that defines the W-cutting surface 806 in depositional space) partitions the first surface 803 and a second edge of the first cutting polygon partitions the second surface 805. Accordingly, reference designator 807 of **FIG. 8B** identifies self-intersection of the first cutting polygon in a U-V plane of depositional space that the first cutting polygon bounds to define the W-cutting surface 806.

Self-intersections of a cutting polygon in depositional space can cause improper triangulation of a cutting surface that is defined by the cutting polygon. For example, triangulation of the cutting surface can involve generating a triangulation topology in depositional space that associates cutting polygon vertices with incorrect sides of a fault. Transforming that triangulation topology to geological space can generate a triangular surface of a depogrid cell in geological space that spans across the fault. Further processing of the first cutting polygon that defines the W-cutting surface 806 to reduce or eliminate the self-intersection 807 can be useful to mitigate improper triangulation of the W-cutting surface 806, as described below. As shown by **FIG. 8A**, the second and third cutting polygons (defining V-cutting surfaces) only partition one surface (e.g., the first surface 803 and the second surface 805, respectively) of the depogrid cell 802 that interfaces with the fault 800. Neither the second cutting polygon nor the third cutting polygon include edges that partition both surfaces of the depogrid cell 802 that interface with the fault 800. The second cutting polygon or the third cutting polygon each avoid self-intersection in depositional space.

A fault edge can refer to an edge of a cutting polygon that partitions a surface of a depogrid cell that interfaces with a side of a fault. As described above with reference to **FIG. 8A**, the depogrid cell 802 includes the first surface 803 and the second surface 805 that interface with the first side and the second side of the fault 800, respectively. As further described above with reference to **FIG. 8A**, the first cutting polygon (that defines the W-cutting surface 806 in depositional space) includes a first fault edge and a second fault edge that partition the first surface 803 and the second surface 805 of the depogrid cell 802, respectively.

Each edge of a cutting polygon has a constant value in at least one coordinate direction (e.g., a cutting direction) of depositional space. Each edge of the first cutting polygon that defines the W-cutting surface 806 has a constant value in the W-direction of depositional space. A non-cutting direction edge can refer to an edge of a cutting polygon that has constant values in two coordinate directions (e.g., a cutting direction and a non-cutting direction) of depositional space. The first cutting polygon that defines the W-cutting surface 806 includes a number of edges that are parallel to the V-direction of depositional space. Each edge of the first cutting polygon that is parallel to the V-direction of depositional space has constant values in both the W-direction and the V-direction of depositional space.

Further processing of the first cutting polygon that defines the W-cutting surface 806 to reduce or eliminate the self-intersection 807 can involve generating new fault edges to replace those existing fault edges of the first cutting polygon. New fault edges generally represent relatively small adjustments applied to existing fault edges in depositional space. No such adjustments are applied to existing fault edges in geological space. Generating a new fault edge involves identifying a vertex of the first cutting polygon that corresponds to a transition between an existing fault edge and a non-cutting direction edge. With reference to **FIG. 8B**, reference designator 809 identifies a vertex of the first cutting polygon that corresponds to a transition between the first fault edge and a non-cutting direction edge. Reference designator 811 identifies a vertex of the first cutting polygon that corresponds to a transition between the second fault edge and a non-cutting direction edge.

Each identified vertex can be repositioned along a corresponding non-cutting direction edge of the first cutting polygon to new positions that satisfy three constraints. The first constraint is that the new position of the identified vertex on the corresponding non-cutting direction edge can be coupled with a tip loop vertex by a straight or substantially straight line within the planar region of depositional space bounded by the first cutting polygon. With reference to **FIG. 8B**, reference designator 813 identifies a tip loop vertex. The tip loop vertex corresponds to a vertex (within the U-V plane of depositional space that is bound by the first cutting polygon) where the first and second fault edges meet. The second constraint is that the new position of the identified vertex on the corresponding non-cutting direction edge cannot be collocated with another identified vertex within the planar region of depositional space bound by the first cutting polygon. The third constraint is that the new position of the identified vertex on the corresponding non-cutting direction edge cannot create overlap between the corresponding non-cutting direction edge and any adjacent non-cutting direction edges.

A comparison between **FIGS. 8B** and **8C** shows the vertex 809 and the vertex 811 each being repositioned along a corresponding non-cutting direction edge to new positions that satisfy each of the three constraints. For example, **FIG. 8C** shows that a new position of the vertex 809: (i) can be coupled with the tip loop vertex 813 by a straight or substantially straight line within the U-V plane of depositional space that is bound by the first cutting polygon; (ii) is not collocated with a new position of the vertex 811; and (iii) does not create overlap between the corresponding non-cutting direction edge and any adjacent non-cutting direction edges. Another example, **FIG. 8C** also shows that a new position of the vertex 811: (i) can be coupled with the tip loop vertex 813 by a straight or substantially straight line within the U-V plane of depositional space that is bound by the first cutting polygon; (ii) is not collocated with a new position of the vertex 809; and (iii) does not create overlap between the corresponding non-cutting direction edge and any adjacent non-cutting direction edges.

Any vertices of an existing fault edge that are located between the identified vertex and the tip loop vertex 813 can be repositioned along a new fault edge replacing the existing fault edge to increase accuracy of a resulting triangulation topology. For example, reference identifier 815 in **FIG. 8B** identifies a vertex of the second fault edge that is located between the vertex 811 and the tip loop vertex 813. A comparison between **FIGS. 8B** and **8C** shows the vertex 815 being repositioned along a new fault edge that is generated to replace the second fault edge. In an embodiment, reducing deviation between a length of a new fault edge and a length of an existing fault edge of the first cutting polygon can reduce triangulation topology distortion induced by transforming the W-cutting surface 806 to geological space.

Additional control points can be generated in depositional space to define the W-cutting surface 806, in a similar manner as described above with reference to the other subdivision cases. Each additional control point is identified by a cross or an "X" in **FIGS. 8B** and **8C**. **FIGS. 8B** and **8C** show six additional control points being generated in depositional space to define the W-cutting surface 806. A depositional space representation of the depogrid cell 802 can include two planar quadrilateral surfaces ("W-surfaces") in the W-direction of depositional space. In depositional space, specific vertices on a given W-surface of that depositional space representation of the depogrid cell 802 can be selected to provide fixed starting points on the given W-surface for rays to generate each additional control point. A geological space representation of each vertex selected on a given W-surface to provide a fixed starting point for a ray to generate an additional control point is identified by a circle in **FIG. 8A**. In an embodiment, repositioning an identified vertex along a corresponding non-cutting direction edge involves satisfying a fourth constraint in addition to the three constraints discussed above. The fourth constraint is that a new position of the identified vertex on the corresponding non-cutting direction edge cannot transition an additional control point from one side of a fault to another side of the fault. Satisfying the fourth constraint can increase an accuracy of a resulting triangulation topology.

Triangulation can occur in depositional space before the W-cutting surface 806 is transformed to geological space. Triangulation of the W-cutting surface 806 can be implemented using vertices of the first cutting polygon, the additional control points, and a correspondence mapping between depositional space and geological space, in a similar manner as described above with reference to the other subdivision cases. Application of the W-cutting surface 806 to a depositional space representation of the depogrid cell 802 forms child depogrid cells in depositional space. A geological space representation of the W-cutting surface 806 provides common intermediate surfaces between the child depogrid cells in geological space. In some instances, multiple dying faults can occur in the same depogrid cell. In such instances, multiple dying faults crossing a depogrid cell without fully cutting the depogrid cell may render the depogrid cell unsuitable for subdivision.

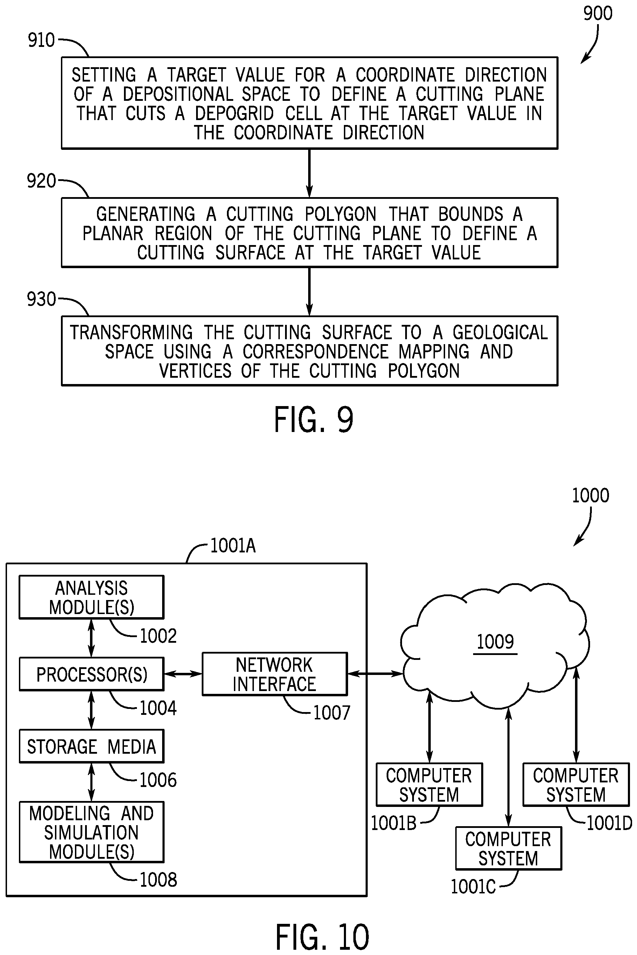

**FIG. 9** illustrates a process flow diagram of a method 900 for subdividing depogrid cells of an unstructured grid, in accordance with an aspect of the present disclosure. Although the method 900 is described in a particular order, it should be noted that the method 900 may be performed in any suitable order. At block 910, the method 900 includes setting a target value for a coordinate direction of a depositional space to define a cutting plane that cuts a depogrid cell at the target value in the coordinate direction.

At block 920, the method 900 includes generating a cutting polygon that bounds a planar region of the cutting plane to define a cutting surface at the target value. The cutting surface may subdivide the depogrid cell into a plurality of depogrid cells in the coordinate direction. The cutting surface may also provide common planar surfaces between the plurality of depogrid cells in the depositional space. In an embodiment, the depogrid cell is a dying fault cell. In an embodiment, generating the cutting polygon includes generating a new fault edge that replaces an existing fault edge in the cutting polygon to reduce self-intersection of the cutting polygon in the depositional space. In an embodiment, generating the new fault edge includes identifying a vertex of the cutting polygon that corresponds to a transition between the existing fault edge and a non-cutting direction edge of the cutting polygon. In an embodiment, generating the new fault edge also includes repositioning the vertex along the non-cutting direction edge of the cutting polygon using a tip loop vertex on a surface of the depogrid cell.

At block 930, the method 900 includes transforming the cutting surface to a geological space using a correspondence mapping and vertices of the cutting polygon. The correspondence mapping may define a relationship between depositional coordinates that define the depositional space and geological coordinates that define the geological space. The cutting surface may provide common non-planar surfaces between the plurality of depogrid cells in the geological space.

In an embodiment, the depogrid cell may define a volume in a depogrid at a first resolution. In an embodiment, the method 900 includes replacing the depogrid cell in the depogrid with the plurality of depogrid cells. The plurality of depogrid cells may define the volume in the depogrid at a second resolution that is higher than the first resolution. In an embodiment, the method 900 includes triangulating the cutting surface in the depositional space using the vertices of the cutting polygon prior to transforming the cutting surface to the geological space. In an embodiment, the method 900 includes generating a control point in the depositional space using a ray that extends orthogonally with respect to the cutting plane. The control point may further define the cutting surface. In an embodiment, the ray is fixed to a well top vertex on a surface of the depogrid cell in the depositional space. In an embodiment, the method 900 includes determining a location of the control point in the depositional space using Barycentric coordinates applied to a triangular surface of the depogrid cell in the depositional space. In an embodiment, the method 900 includes determining a location of the control point in the geological space using linear interpolation and a point on a surface of the depogrid cell where the ray and the surface intersect.

In an embodiment, the cutting plane may be a first cutting plane. In an embodiment, the method 900 includes generating a vertex within the depogrid cell where the first cutting plane intersects a second cutting plane to define an edge of the cutting surface. The first cutting plane and the second cutting plane may be orthogonal in the depositional space. In an embodiment, the method 900 includes triangulating the cutting surface in the depositional space using a vertex prior to transforming the cutting surface to the geological space. The vertex may be within the depogrid cell where the first cutting plane intersects a second cutting plane that is orthogonal to the first cutting plane in the depositional space.

In an embodiment, the depogrid cell includes a surface with an edge that interfaces with an unconformity. In an embodiment, the method 900 includes generating a control point in the depositional space using a ray that is fixed to a vertex on the surface of the depogrid cell that is remote from the edge of the surface that interfaces with the unconformity. The control point may further define the cutting surface. In an embodiment, the control point is a first control point. In an embodiment, the method 900 includes generating a second control point in the depositional space using a well top vertex that is located on the surface with the edge that interfaces with the unconformity. The second control point may further define the cutting surface. In an embodiment, a fault interfaces with a surface of the depogrid cell and the cutting surface subdivides the surface into a plurality of surfaces. In an embodiment, the method 900 includes generating a control point in the depositional space using a ray that is fixed to a vertex on an edge of the surface that interfaces with the fault. The control point may further define the cutting surface.

In some embodiments, the methods of the present disclosure may be executed by a computing system. **FIG. 10** illustrates an example of such a computing system 1000, in accordance with some embodiments. The computing system 1000 may include a computer or computer system 1001A, which may be an individual computer system 1001A or an arrangement of distributed computer systems. The computer system 1001A includes one or more analysis modules 1002 that are configured to perform various tasks according to some embodiments, such as one or more methods disclosed herein. To perform these various tasks, the analysis module 1002 executes independently, or in coordination with, one or more processors 1004, which is (or are) connected to one or more storage media 1006. The processor(s) 1004 is (or are) also connected to a network interface 1007 to allow the computer system 1001A to communicate over a data network 1009 with one or more additional computer systems and/or computing systems, such as 1001B, 1001C, and/or 1001D (note that computer systems 1001B, 1001C and/or 1001D may or may not share the same architecture as computer system 1001A, and may be located in different physical locations, e.g., computer systems 1001A and 1001B may be located in a processing facility, while in communication with one or more computer systems such as 1001C and/or 1001D that are located in one or more data centers, and/or located in varying countries on different continents). A processor may include a microprocessor, microcontroller, processor module or subsystem, programmable integrated circuit, programmable gate array, or another control or computing device.

The storage media 1006 may be implemented as one or more computer-readable or machine-readable storage media. Note that while in the example embodiment of **FIG. 10** storage media 1006 is depicted as within computer system 1001A, in some embodiments, storage media 1006 may be distributed within and/or across multiple internal and/or external enclosures of computing system 1001A and/or additional computing systems. Storage media 1006 may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLURAY^{®} disks, or other types of optical storage, or other types of storage devices. Note that the instructions discussed above may be provided on one computer-readable or machine-readable storage medium or may be provided on multiple computer-readable or machine-readable storage media distributed in a large system having possibly plural nodes. Such computer-readable or machine-readable storage medium or media is (are) considered to be part of an article (or article of manufacture). An article or article of manufacture may refer to any manufactured single component or multiple components. The storage medium or media may be located either in the machine running the machine-readable instructions or located at a remote site from which machine-readable instructions may be downloaded over a network for execution.

In some embodiments, computing system 1000 contains one or more modeling and simulation module(s) 1008. In the example of computing system 1000, computer system 1001A includes the modeling and simulation module 1008. In some embodiments, a single modeling and simulation module may be used to perform some aspects of one or more embodiments of the methods disclosed herein. In other embodiments, a plurality of modeling and simulation modules may be used to perform some aspects of methods herein.

It should be appreciated that computing system 1000 is merely one example of a computing system, and that computing system 1000 may have more or fewer components than shown, may combine additional components not depicted in the example embodiment of **FIG. 10**, and/or computing system 1000 may have a different configuration or arrangement of the components depicted in **FIG. 10**. The various components shown in **FIG. 10** may be implemented in hardware, software, or a combination of both hardware and software, including one or more signal processing and/or application specific integrated circuits.

Further, the steps in the processing methods described herein may be implemented by running one or more functional modules in information processing apparatus such as general-purpose processors or application specific chips, such as ASICs, FPGAs, PLDs, or other appropriate devices. These modules, combinations of these modules, and/or their combination with general hardware are included within the scope of the present disclosure.

Computational interpretations, models, and/or other interpretation aids may be refined in an iterative fashion; this concept is applicable to the methods discussed herein. This may include use of feedback loops executed on an algorithmic basis, such as at a computing device (e.g., computing system 1000 of **FIG. 10**), and/or through manual control by a user who may make determinations regarding whether a given step, action, template, model, or set of curves has become sufficiently accurate for the evaluation of the subsurface three-dimensional geologic formation under consideration.

While the embodiments set forth in this disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

## Claims

1. A method comprising:
setting a target value for a coordinate direction of a depositional space to define a cutting plane that cuts a depogrid cell at the target value in the coordinate direction;
generating a cutting polygon that bounds a planar region of the cutting plane to define a cutting surface at the target value that subdivides the depogrid cell into a plurality of depogrid cells in the coordinate direction, wherein the cutting surface provides common planar surfaces between the plurality of depogrid cells in the depositional space; and
transforming the cutting surface to a geological space using a correspondence mapping and vertices of the cutting polygon, wherein the correspondence mapping defines a relationship between depositional coordinates that define the depositional space and geological coordinates that define the geological space, and the cutting surface provides common non-planar surfaces between the plurality of depogrid cells in the geological space.

2. The method of claim 1, wherein the depogrid cell defines a volume in a depogrid at a first resolution, and the method further comprises:
replacing the depogrid cell in the depogrid with the plurality of depogrid cells, wherein the plurality of depogrid cells define the volume in the depogrid at a second resolution that is higher than the first resolution.

3. The method of claim 1, further comprising:
triangulating the cutting surface in the depositional space using the vertices of the cutting polygon prior to transforming the cutting surface to the geological space.

4. The method of claim 1, wherein the cutting plane is a first cutting plane, the method further comprising:
generating a vertex within the depogrid cell where the first cutting plane intersects a second cutting plane to define an edge of the cutting surface, wherein the first cutting plane and the second cutting plane are orthogonal in the depositional space.

5. The method of claim 1, wherein the cutting plane is a first cutting plane, the method further comprising:
triangulating the cutting surface in the depositional space using a vertex prior to transforming the cutting surface to the geological space, wherein the vertex is within the depogrid cell where the first cutting plane intersects a second cutting plane that is orthogonal to the first cutting plane in the depositional space.

6. The method of claim 1, further comprising:
generating a control point in the depositional space using a ray that extends orthogonally with respect to the cutting plane, wherein the control point further defines the cutting surface,
wherein the ray is preferably fixed to a well top vertex on a surface of the depogrid cell in the depositional space.

7. The method of claim 6, further comprising:
determining a location of the control point in the depositional space using Barycentric coordinates applied to a triangular surface of the depogrid cell in the depositional space and/or
determining a location of the control point in the geological space using linear interpolation and a point on a surface of the depogrid cell where the ray and the surface intersect.

8. The method of claim 1, wherein the depogrid cell includes a surface with an edge that interfaces with an unconformity, and wherein the method further comprises:
generating a control point in the depositional space using a ray that is fixed to a vertex on the surface of the depogrid cell that is remote from the edge of the surface that interfaces with the unconformity, wherein the control point further defines the cutting surface.
wherein the control point preferably is a first control point, further comprising:
generating a second control point in the depositional space using a well top vertex that is located on the surface with the edge that interfaces with the unconformity, wherein the second control point further defines the cutting surface.

9. The method of claim 1, wherein a fault interfaces with a surface of the depogrid cell, and the cutting surface subdivides the surface into a plurality of surfaces, preferably further comprising:
generating a control point in the depositional space using a ray that is fixed to a vertex on an edge of the surface that interfaces with the fault, wherein the control point further defines the cutting surface.

10. The method of claim 1, wherein the depogrid cell is a dying fault cell, and wherein generating the cutting polygon comprises:
generating a new fault edge that replaces an existing fault edge in the cutting polygon to reduce self-intersection of the cutting polygon in the depositional space,
wherein generating the new fault edge preferably comprises:
identifying a vertex of the cutting polygon that corresponds to a transition between the existing fault edge and a non-cutting direction edge of the cutting polygon; and
repositioning the vertex along the non-cutting direction edge of the cutting polygon using a tip loop vertex on a surface of the depogrid cell.

11. A system comprising:
a processor; and
memory operatively coupled to the processor, the memory storing instructions that, when executed by the processor, cause the system to:
set a target value for a coordinate direction of a depositional space to define a cutting plane that cuts a depogrid cell at the target value in the coordinate direction;
generate a cutting polygon that bounds a planar region of the cutting plane to define a cutting surface at the target value that subdivides the depogrid cell into a plurality of depogrid cells in the coordinate direction;
triangulate the cutting surface in the depositional space using vertices of the cutting polygon to create a set of triangular surfaces, wherein the set of triangular surfaces provides common planar surfaces between the plurality of depogrid cells in the depositional space; and
transform the set of triangular surfaces to a geological space using a correspondence mapping and the vertices of the cutting polygon, wherein the correspondence mapping defines a relationship between depositional coordinates and geological coordinates, and the set of triangular surfaces provides common non-planar surfaces between the plurality of depogrid cells in the geological space.

12. The system of claim 11, further comprising instructions that, when executed by the processor, cause the system to:
generate a control point in the depositional space using a ray that extends orthogonally with respect to the cutting plane, wherein the control point further defines the cutting surface.

13. The system of claim 11, further comprising instructions that, when executed by the processor, cause the system to:
replace a cell node that represents the depogrid cell in a graph structure with a plurality of cell nodes, wherein each cell node of the plurality of cell nodes represents a different depogrid cell of the plurality of depogrid cells.

14. The system of claim 11, wherein the graph structure is a directional hierarchical acyclic graph structure.

15. A non-transitory computer-readable medium comprising computer-executable instructions that, when executed, are configured to cause a processor to perform operations comprising:
setting, by the processor, a target value for a coordinate direction of a depositional space to define a cutting plane that cuts a depogrid cell at the target value in the coordinate direction;
generating, by the processor, a cutting polygon that bounds a planar region of the cutting plane at the target value;
generating, by the processor, a control point in the depositional space using a ray that extends orthogonally with respect to the cutting plane, wherein the cutting polygon and the control point define a cutting surface at the target value that subdivides the depogrid cell into a plurality of depogrid cells in the coordinate direction, and the cutting surface provides common planar surfaces between the plurality of depogrid cells in the depositional space; and
transforming, by the processor, the cutting surface to a geological space using a correspondence mapping, the control point, and vertices of the cutting polygon, wherein the correspondence mapping defines a relationship between depositional coordinates and geological coordinates, and the cutting surface provides common non-planar surfaces between the plurality of depogrid cells in the geological space.
